# EUROPEAN PATENT APPLICATION

(11) **EP 3 312 706 A1**
(43) Date of publication of application: **25.04.2018**
(21) Application number: 16811981.6
(22) Date of filing: 17.06.2016
(51) Int. Cl.: G06F 3/041, G06F 3/0488, G01L 1/14, G01L 1/18, G01L 1/20

(54) **ELECTRONIC DEVICE HAVING INPUT DEVICE**

(30) Priority: 18.06.2015 KR 20150086915; 08.01.2016 KR 20160002904
(71) Applicant: Samsung Electronics Co., Ltd., Gyeonggi-do 16677 (KR)
(72) Inventor: CHO, Eun-Sung, Ansan-si Gyeonggi-do 15478 (KR); KIM, Yong-Hwan, Seoul 05259 (KR); KIM, Jung-Won, Hwaseong-si Gyeonggi-do 18443 (KR); KIM, Ji-Yong, Seoul 05527 (KR)
(74) Representative: HGF Limited
(86) International application number: PCT/KR2016/006475
(87) International publication number: WO 2016/204568

(57) **Abstract**

According to various examples of the present invention, an electronic device including a pressure sensing type input device can comprise: a display panel in which a touch panel and a display panel for displaying a screen are stacked, the displaying panel being stacked on one side of the touch panel; and at least one pressure sensor unit disposed on a rear surface of the display panel, sensing the pressure generated in the display panel, and implementing an input according to the pressure. The electronic device including a pressure sensing type input device can be variously implemented according to examples.

## Description

### [Technical Field]

Various embodiments of the present disclosure relate to an electronic device including an input device.

### [Background Art]

Buttons for inputting information to an electronic device may be designed in various forms according to the uses thereof, but may adopt physical buttons for providing a physical tactile sensation and buttons in the form of icons for visually expressing the meaning of the buttons as a basic configuration. In addition, buttons for inputting information to an electronic device include buttons attached to a computer keyboard, operation buttons of various portable devices (e.g., a phone book, a terminal, an electronic organizer, and a game machine), remote controllers, buttons attached to various electronic products, etc.

### [Detailed Description of the Invention]

### [Technical Problem]

A recent bar-type electronic device, such as a smart phone, includes a large touch panel provided on the front face thereof. Such an electronic device is provided, on a side face, a central portion, a peripheral portion, or the like thereof, with button keys, such as a side key and a central on/off key, as separate physical buttons so as to execute the on/off of power, to execute input and cancellation operations, or to execute a camera, to control the volume, to lock/unlock a display unit, or the like, as well as to perform an input through the display device on the front face thereof.

As described above, in implementing an input to an electronic device, a touch-based input, in which touch or proximity with respect to a display unit is recognized, may co-exist with mechanical-type input using a physical button key or the like.

A mechanical-type button key, such as a physical button key, provided on an electronic device, is formed on the periphery of the display device, for example, on a bezel area or a side face portion of the electronic device. The number of components constituting the mechanical button keys is large, and providing space for mounting the button keys entails a problem of making the realization of the slimness more difficult.

Recently, a display device provided in an electronic device has become very important in the electronic device. In particular, a recent display device may be bent to extend to a peripheral portion of the front face of the electronic device, for example, a portion of a side face, as well as being provided on the front face of the electronic device. Accordingly, it is inevitable that the space for mounting mechanical-type button keys on a side face of the display device is narrowed. Moreover, the mounting space for the button keys may not be provided, or the space for bending the display device to the side face may not be provided.

Further, as the display device is bent to the side face of the electronic device, it is unavoidable for an input device implemented through an existing display device, such as a touch panel to be bent. When the touch panel is bent, the positions of stacked structures may be changed according to the bending of the touch panel, and as a result, in the case of an input through the side face of the electronic device, the touch of the object may not be recognized or may be weakly recognized.

In addition, in the case of the side face of the display device, frequent touches may frequently occur when the touch panel is held in the user's hand, and malfunctions due to an erroneous touch may frequently occur in comparison with the front face while the display device is being carried.

Accordingly, the present disclosure provides an electronic device including a display device that is bent, rolled or folded on the front face of the electronic device, and further including a pressure-sensitive input device that is capable of implementing a stable input, like a mechanical button conventionally provided on a side face.

In addition, the present disclosure also provides an electronic device including a pressure-sensitive input device that is capable of implementing input in response to being pressed without being exposed to the outside of the electronic device, unlike an input device that implements input in response to being pressed while being exposed in an existing electronic device.

Further, the present disclosure provides an electronic device including a pressure-sensitive input device that is capable of implementing an aesthetic sense and high quality of an electronic device and is capable of preventing unintentional driving of the electronic device due to the external environment or erroneous operation.

### [Technical Solution]

An electronic device having a pressure-sensitive input device according to various embodiments of the present disclosure may include: a display panel including a touch panel and a display panel stacked on one face of the touch panel so as to display a screen; and at least one pressing sensor unit that is disposed on a rear face of the display panel so as to sense pressing performed on the display panel and to implement an input according to the pressing.

In addition, an electronic device according to various embodiments of the present disclosure may include: a cover that forms at least a portion of an outer surface of the electronic device; a capacitance-sensing unit formed adjacent to one face of the cover; and a pressure-sensing unit formed adjacent to one face of the capacitance-sensing unit; and a processor. The processor may be set to confirm a position corresponding to a user input adjacent to the cover using the capacitance-sensing unit and to perform the first designated function based at least on the position when situation information related to the electronic device satisfies a first designated condition, and may be set to confirm a pressure corresponding to the user input using the capacitance-sensing unit and the pressure-sensing unit and perform the second designated function based at least on the pressure when the situation information satisfies a second designated condition.

In addition, an electronic device according to various embodiments of the present disclosure may include: a cover that forms at least a portion of an outer surface of the electronic device; a capacitance-sensing unit that is formed adjacent to one face of the cover and reacts to a user input acquired through the cover so as to sense a variation in capacitance corresponding to the user input; and a pressure-sensing unit that is formed adjacent to one face of the capacitance-sensing unit and is selectively activated based on the user input or the situation information for the electronic device so as to sense a variation in pressure corresponding to the user input.

Further, an input device according to various embodiments of the present disclosure may include: a first input unit that implements an input in response to a user input according to at least one of pressing and a touch; and a second input unit that is disposed above a position of the first input unit. The second input unit may include: a first sensing unit that reacts to user input acquired through the cover so as to sense a variation in capacitance corresponding to the user input; and a second sensing unit that is formed adjacent to one face of the first sensing unit so as to senses a variation in pressure corresponding to the user input. When situation information, which satisfies a designated condition, is input to the input device, at least one of the first sensing unit and the second sensing unit may be activated so as to perform the designated function.

Therefore, an electronic device having a pressure-sensitive input device according to various embodiments of the present disclosure includes the pressure-sensitive input unit is provided inside the display device, so that input via pressing can be implemented without exposing the input unit to the outside of the electronic device. Since the input unit is not exposed to the outside of the electronic device, it is possible to increase the degree of freedom of design of the electronic device, to implement an aesthetically pleasing and high-quality electronic device, and to prevent unintentional driving of the electronic device due to the external environment or erroneous operation.

In addition, an electronic device including a pressure-sensitive input device according to various embodiments of the present disclosure may be provided with a large screen by allowing a display device mounted on the electronic device to be bent, rolled or folded to the peripheral portion of the front face of the electronic device, and various user environments may be realized through input performed by touching the bent portion and an input through the pressure-sensitive type input unit.

### [Brief Description of Drawings]

The above and other aspects, features and advantages of the present disclosure will be more apparent from the following detailed description taken in conjunction with the accompanying drawings, in which:
FIG. 1 is a schematic perspective view of an electronic device including a pressure-sensitive input device according to various embodiments of the present disclosure;
Figure 2 is a schematic cross-sectional view of the electronic device including the pressure-sensitive input device according to various embodiments of the present disclosure;
FIG. 3 is a schematic exploded cross-sectional view illustrating a side of the electronic device including the pressure-sensitive input device according to various embodiments of the present disclosure;
Figure 4 is a schematic cross-sectional view illustrating the side of the electronic device including the pressure-sensitive input device in various embodiments of the present disclosure, in an assembled state;
Figure 5 is a schematic cross-sectional view illustrating a lower portion of the electronic device including the pressure-sensitive input device according to various embodiments of the present disclosure;
FIG. 6 is a view illustrating a pressing sensor unit mounting structure in the electronic device including the pressure-sensitive input device according to various embodiments of the present disclosure;
FIG. 7 is a view illustrating a schematic stack structure in the case in which a pair of pressing sensor units is provided in the electronic device including the pressure-sensitive input device according to various embodiments of the present disclosure;
FIG. 8 is a block diagram schematically illustrating a user environment executed in the electronic device according to input driving on a second screen region in the electronic device including the pressure-sensitive input device according to various embodiments of the present disclosure;
FIG. 9 is a block diagram schematically illustrating a user environment executed in the electronic device according to input driving on an opaque layer in the electronic device including the pressure-sensitive input device according to various embodiments of the present disclosure;
FIG. 10 is a view illustrating input devices mounted on the front face and a side face in the electronic device according to various embodiments of the present disclosure;
FIG. 11 is a view illustrating input devices mounted on the rear face and other side faces in the electronic device according to various embodiments of the present disclosure;
FIG. 12 is a view schematically illustrating a state of mounting input devices inside the electronic device according to various embodiments of the present disclosure;
FIG. 13 is an exploded perspective view illustrating at least one input device in the electronic device according to various embodiments of the present disclosure;
FIG. 14 is a block diagram schematically illustrating an operation according to the driving of a second input unit in the electronic device according to various embodiments of the present disclosure;
FIG. 15 is a block diagram schematically illustrating an operation according to the driving of an input device in the electronic device according to various embodiments of the present disclosure;
FIG. 16 is a view schematically illustrating input devices and a timing chart of the input device according to a user input in the electronic device according to various embodiments of the present disclosure;
FIGS. 17 to 31 are a view illustrating embodiments, in which various functions according to input devices are implemented in the electronic device according to various embodiments of the present disclosure;

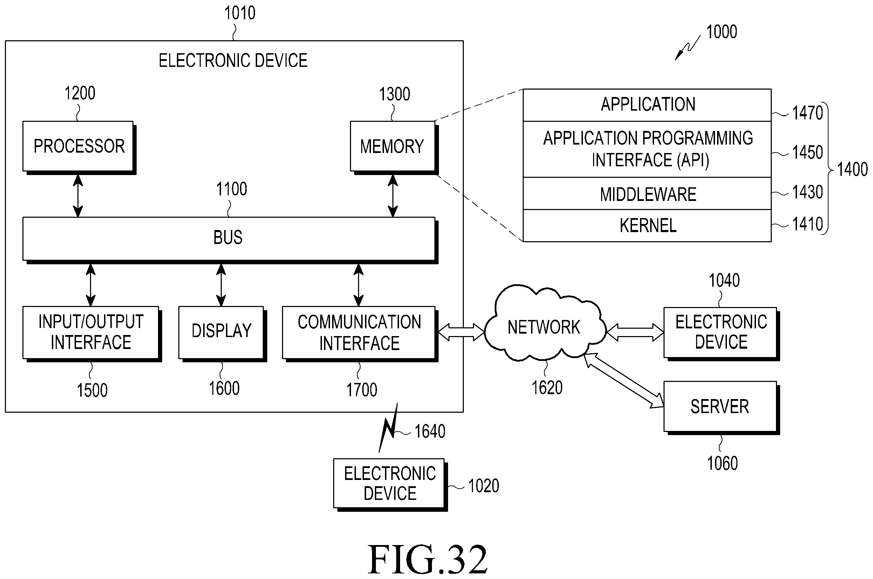

FIG. 32 is a view illustrating an electronic device within a network environment in various embodiments;
FIG. 33 is a block diagram of an electronic device according to various embodiments; and
FIG. 34 is a block diagram illustrating a program module according to various embodiments.

### [Mode for Carrying out the Invention]

As the present disclosure allows for various changes and numerous embodiments, some exemplary embodiments will be described in detail with reference to the accompanying drawings. However, it should be understood that the present disclosure is not limited to the specific embodiments, but the present disclosure includes all modifications, equivalents, and alternatives within the spirit and the scope of the present disclosure. In describing the drawings, similar reference numerals may be used to designate similar constituent elements.

Although ordinal terms such as "first" and "second" may be used to describe various elements, these elements are not limited by the terms. The terms are used merely for the purpose to distinguish an element from the other elements. For example, a first element could be termed a second element, and similarly, a second element could be also termed a first element without departing from the scope of the present disclosure. As used herein, the term "and/or" includes any and all combinations of one or more associated items.

Further, the relative terms "a front surface", "a rear surface", "a top surface", "a bottom surface", and the like which are described with respect to the orientation in the drawings may be replaced by ordinal numbers such as first and second. In the ordinal numbers such as first and second, their order are determined in the mentioned order or arbitrarily and may not be arbitrarily changed if necessary.

In the present disclosure, the terms are used to describe specific embodiments, and are not intended to limit the present disclosure. As used herein, the singular forms are intended to include the plural forms as well, unless the context clearly indicates otherwise. In the description, it should be understood that the terms "include" or "have" indicate existence of a feature, a number, a step, an operation, a structural element, parts, or a combination thereof, and do not previously exclude the existences or probability of addition of one or more another features, numeral, steps, operations, structural elements, parts, or combinations thereof.

Unless defined differently, all terms used herein, which include technical terminologies or scientific terminologies, have the same meaning as that understood by a person skilled in the art to which the present disclosure belongs. Such terms as those defined in a generally used dictionary are to be interpreted to have the meanings equal to the contextual meanings in the relevant field of art, and are not to be interpreted to have ideal or excessively formal meanings unless clearly defined in the present specification.

In the present disclosure, an electronic device may be a random device, and the electronic device may be called a terminal, a portable terminal, a mobile terminal, a communication terminal, a portable communication terminal, a portable mobile terminal, a touch screen or the like.

For example, the electronic device may be a smartphone, a portable phone, a game player, a TV, a display unit, a heads-up display unit for a vehicle, a notebook computer, a laptop computer, a tablet Personal Computer (PC), a Personal Media Player (PMP), a Personal Digital Assistants (PDA), and the like. The electronic device may be implemented as a portable communication terminal which has a wireless communication function and a pocket size. Further, the electronic device may be a flexible device or a flexible display device.

The electronic device may communicate with an external electronic device, such as a server or the like, or perform an operation through an interworking with the external electronic device. For example, the electronic device may transmit an image photographed by a camera and/or position information detected by a sensor unit to the server through a network. The network may be a mobile or cellular communication network, a Local Area Network (LAN), a Wireless Local Area Network (WLAN), a Wide Area Network (WAN), an Internet, a Small Area Network (SAN) or the like, but is not limited thereto.

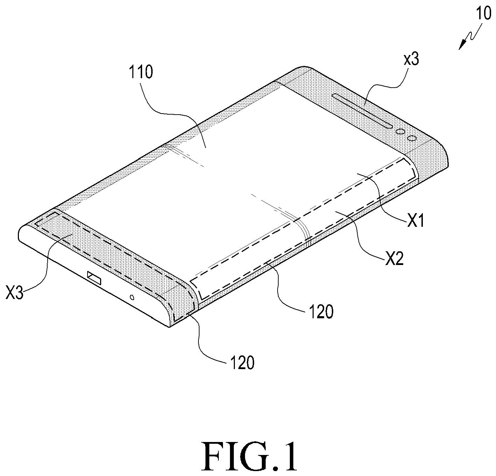

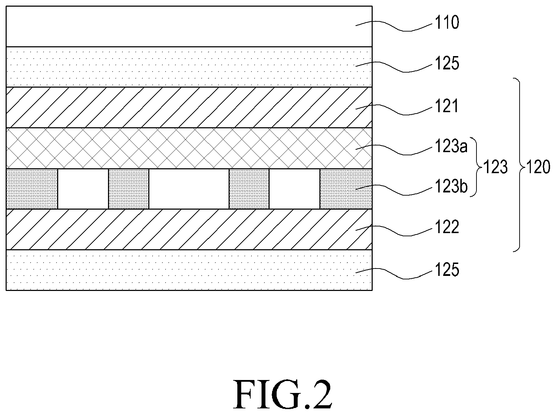

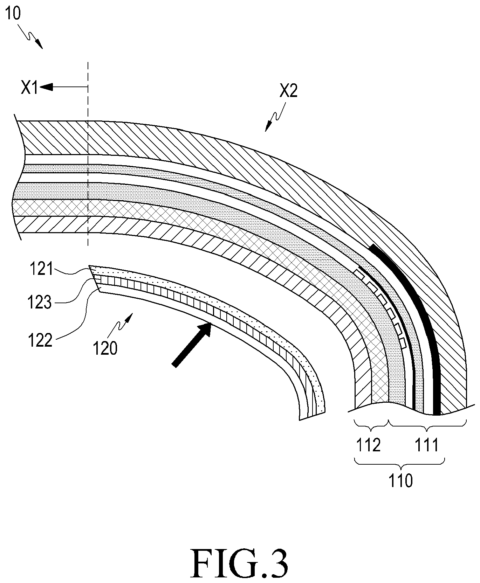

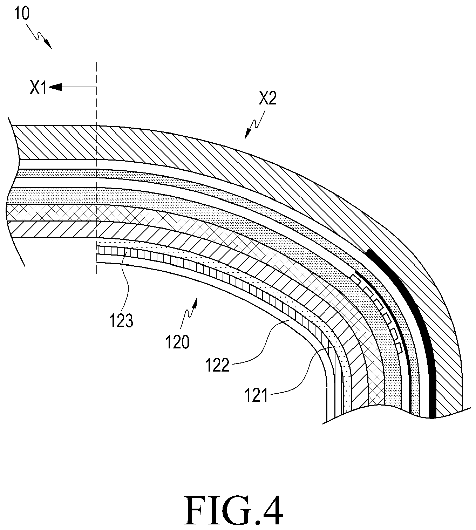

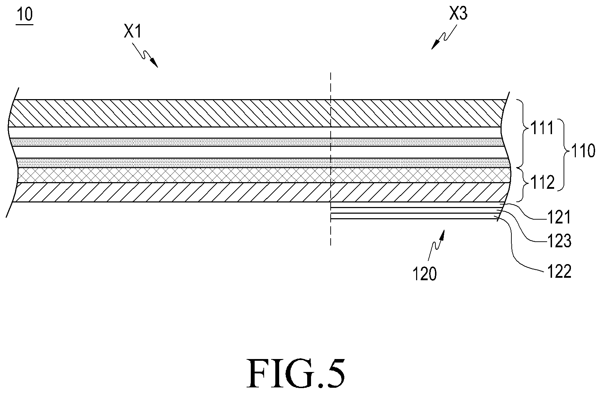

FIG. 1 is a schematic perspective view illustrating an electronic device 10 including a pressure-sensitive input device according to various embodiments of the present disclosure. FIG. 2 is a schematic cross-sectional view illustrating the electronic device 10 including the pressure-sensitive input device according to various embodiments of the present disclosure. FIG. 3 is a schematic exploded cross-sectional view illustrating a side of the electronic device 10 including the pressure-sensitive input device according to various embodiments of the present disclosure. FIG. 4 is a schematic cross-sectional view illustrating the side of the electronic device 10 including the pressure-sensitive input device according to various embodiments of the present disclosure, in the assembled state. FIG. 5 is a schematic cross-sectional view illustrating a lower portion of the electronic device 10 including the pressure-sensitive input device according to various embodiments of the present disclosure.

Referring to FIGS. 1 to 5, the electronic device 10 may include a display panel 110 and a pressing sensor unit 120.

The display panel 110 may implement an input according to the touch or proximity of an object, and may display an image according to a user environment. The display panel 110 may be disposed on at least one face of the main body, and may include a touch panel 111 and a display panel 112, which is stacked on one face of the touch panel 111 so as to display a screen.

The display panel 110 may display input made via a capacitive object, such as a hand, or an input device, such as a digitizer pen or a stylus pen, or output in response to the input. The display panel 110 according to various embodiments of the present disclosure may receive an input of continuous movement of at least one touch among one or more touches. In various embodiments of the present disclosure, "touch" is not limited to a direct touch of the user's body or an input device with the display panel 110, and may include non-touch, for example, proximity. In addition, an interval that can be detected by the display panel 110 may be changed according to the performance or structure of the electronic device 10.

As mentioned above, the display panel 110 may include a window cover (not illustrated), a touch panel 111, a display panel 112, and an adhesive member for bonding the panels to each other, and the panels may be arranged by being stacked. In addition, the display panel 110 may be seated on and supported by a bracket 11 mounted inside the electronic device 10. For example, the display panel 110 may be supported and seated on the bracket 11 mounted inside the electronic device 10, and may be exposed to one face of the electronic device 10.

The display panel 112 may include at least one of displays, such as a Liquid Crystal Display (LCD), a Light-Emitting Display (LED), an Organic Light-Emitting Diode (OLED) display, and an Active Organic Light-Emitting Diode (AMOLED) display. The display panel 110 may display various images according to various operation states, application execution, services, etc. implemented in the electronic device 10.

The touch panel 111 may be configured to implement an input according to the touch, proximity, or the like of an object. According to various embodiments of the present disclosure, the touch panel 111 may be implemented in various types, such as a capacitance-type touch panel 111, an electromagnetic resonance-type touch panel 111, a resistive-type touch panel 111, an infrared (IR)-type touch panel 111, an electromagnetic induction-type touch panel 111, and an ultrasonic wave-type touch panel 111, or the above-mentioned touch panels may be implemented in combination.

The display panel 110, in which the panels are stacked, may be divided into a screen section including a first screen region X1 and a second screen region X2 bent from the first view region X1, and a non-screen region X3, in which a circuit board 329, on which connection lines, a touch IC, etc., to be described are mounted may be disposed, and is covered by an opaque layers X3 (hereinafter, referred to as an "opaque layer X3").

Through the display panel 110, e.g. a screen display section, an input (hereinafter, referred to as a "first input") may be executed, and button icons may be displayed on the screen section for the first input. That is, the electronic device 10 may provide button icons to the user as visual information in response to a button input through the display panel 110.

In a side face or non-screen region of the electronic device 10, a pressing sensor unit 120 may be provided for input (hereinafter, referred to as a "second input") different from the first input executed through the screen section. The second input may be, for example, input for a volume key, power, or execution of a pre-set multimedia.

The pressing sensor unit 120 is configured to be bonded to the rear face of the display panel 110. For example, the pressing sensor unit 120 is configured to be seated between the display panel 110 and the bracket 11, for example. One or more pressing sensor units 120 may be disposed between the rear face of the electronic device 10, e.g., display panel 110 and the bracket 11 in order to recognize a pressure such as pressing and to implement input accordingly. The pressing sensor unit 120 according to an embodiment of the present disclosure may be disposed on the inner rear face of the display panel 110 (e.g., the inside of the second screen region X2) along the side faces around the electronic device 10. Unlike this, the pressing sensor unit 120 may be disposed on the inner rear face of the opaque layer X3 disposed around the screen display section (e.g., the inner rear face of the opaque layer X3 disposed below the first screen region XI).

The pressing sensor unit 120 may include a second conductive member 122 and a sensor member 123, and the sensor member 123 may include a pressure-sensitive layer 123a and a spacer layer 123b.

The first and second conductive members 121 and 122 may have a symmetrical structure and may be formed of a flexible circuit board or the like. For example, a conductive layer or an electrode layer may be formed on each substrate panel, and may be disposed on the upper or lower face of the pressure-sensitive layer 123a and the spacer layer 123b.

As described above, the sensor member 123 may include the pressure-sensitive layer 123a and the spacer layer 123b, and may be disposed between the first conductive member 121 and the second conductive member 122.

The pressure-sensitive layer 123a may be disposed between the first conductive member 121 and the second conductive member 122, and may be a constituent matter having a resistance that is variable according to a pressure applied in response to the touching of the object. The pressure-sensitive layer 123a may include a material having a resistance that is linearly variable due to a pressure generated at the time of touching an object. For example, the pressure-sensitive layer 123a may include a material such as a Quantum Tunneling Composite (QTC) using Ni particles as a conductive material. Otherwise, the pressure-sensitive layer 123a may be fabricated using a polymer material, such as rubber, as a base material and mixing conductive particles at a suitable ratio to the polymer material. When a force or a pressure is applied to the pressure-sensitive layer 123a, the material shrinks and the spacing of particles decreases so that a current can flow. As such a material, a conductive rubber using carbon black as electrically conductive particles or a Force-Sensing Resistor (FSR) may be exemplary.

The spacer layer 123b may be provided to fix the pressure-sensitive layer 123a to space the same apart from at least one of the first conductive member 121 and the second conductive member 122. The spacer layer 123b according to an embodiment of the present disclosure may be made of, for example, a silicon material. However, without being limited thereto, the spacer layer 123b may be made of a material including urethane.

The pressing sensor unit 120 according to an embodiment of the present disclosure has been described as including the first conductive member 121, the pressure-sensitive layer 123a, the spacer layer 123b, and the second conductive member 122, which are stacked in this order on the rear face of the display panel 110. However, the present disclosure is not limited thereto. For example, as in the case in which in the pressing sensor unit 120, the first conductive member 121, the spacer layer 123b, the pressure-sensitive layer 123a, and the second conductive member 122 are stacked on the rear face of the display panel 110 in this order, the spacer layer 123b may be interchanged in position with the pressure-sensitive layer 123a.

Elastic supports 127 may be provided on the opposite side faces of the pressing sensor unit 120, respectively, so that when the display panel 110 is pressed, the display panel 110 is capable of being pressed to the position of the pressing sensor unit 120 and then being restored.

The elastic supports 127 may be coupled between the display panel 110 and the bracket 11 with a thickness corresponding to the mounting space of the pressing sensor unit 120 on the opposite sides of the pressing sensor unit 120, may provide elasticity according to the pressing of the pressing sensor unit 120, and may be provided such that the pressing sensor unit 120 may be mounted and supported between the display panel 110 and the bracket 11. The elastic supports 127 according to an embodiment of the present disclosure may be a double-sided tape made of an elastic material, for example, a material including at least one of rubber, silicone, and urethane.

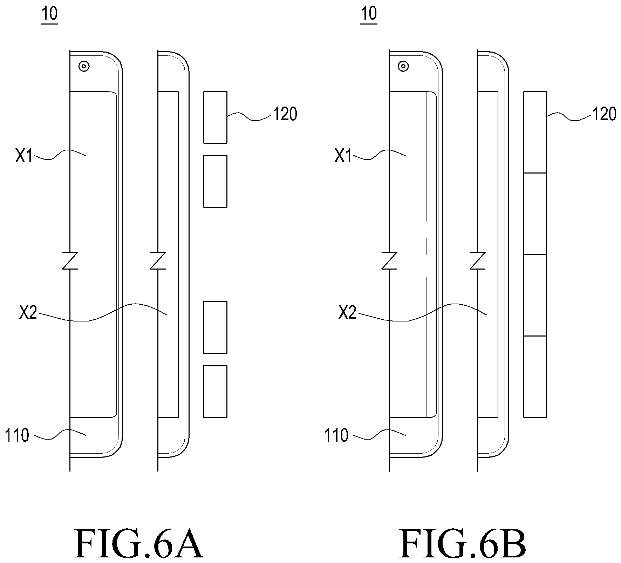

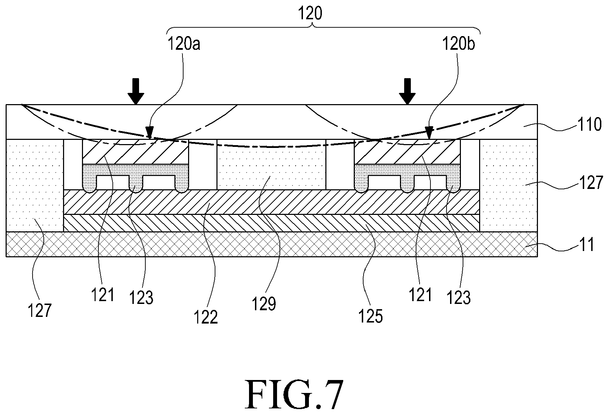

FIG. 6 is a view illustrating a pressing sensor unit 120 mounting structure in the electronic device 10 including the pressure-sensitive input device according to various embodiments of the present disclosure. FIG. 7 is a view illustrating a schematic stack structure in the case in which a pair of pressing sensor units 120 is provided in the electronic device 10 including the pressure-sensitive input device according to various embodiments of the present disclosure.

Referring to FIGS. 6 and 7, as described above, the pressing sensor unit 120 may be provided to implement an input when pressed one or more times, and the number and structure of the pressing sensor units 120 may vary according to the type of input buttons. For example, the pressing sensor unit 120 may be provided on a side face of the electronic device 10 as a side volume button so as to implement volume control or up-and-down movement, or may be provided on a side face of the electronic device 10 as a side power button in order to implement on/off of power. Alternatively, the pressing sensor unit 120 may be mounted in the opaque layer X3 around the screen display unit on the front face of the electronic device 10, and may be provided as menu buttons providing functions, such as execution or selection of a menu, and back. The power button described above may be provided as one pressing sensor unit 120. Unlike this, the side volume button may be provided with at least one pair of pressing sensor units 120. In addition, the menu button may be provided to have at least one structure of one pressing sensor unit 120 or a pair of pressing sensor units 120.

In the case of one pressing sensor unit 120, the first conductive member 121, the sensor member 123, and the second conductive member 122 may be stacked in this order inside the space created by the elastic supports 127 between the display panel 110 and the bracket 11 as described above.

In addition, between the display panel 110 and the first conductive member 121 and between the second conductive member 122 and the bracket 11, a bonding member, such as a double-sided tape, may be stacked such that the top and bottom surfaces of each sensor member 123 can be bonded to the display panel 110 and the bracket 11.

The pressing sensor unit 120 may be provided with two or more pressure sensors (e.g., a pair of pressure sensors), which may be spaced apart from each other along a side face of the electronic device 10, or may be arranged adjacent to each other along the side face of the electronic device 10.

In this case, the pressing sensor unit 120 may include a pair of first pressure sensors 120a and a second pressure sensor 120b adjacent to the first pressure sensors 120a inside the space created between the display panel 110 and the bracket 11 by the elastic supports 127, and an elastic support member 129 may be included between the first pressure sensor 120a and the second pressure sensor 120b in order to limit an interference therebetween according to the pressing.

The first pressure sensor 120a may be disposed between one of the elastic supports 127 disposed between the display panel 110 and the bracket 11 and the elastic support member 129. The second pressure sensor 120b may be disposed between another one of the elastic supports 127 disposed between the display panel 110 and the bracket 11 and the elastic support member 129.

The first pressure sensor 120a and the second pressure sensor 120b may be formed on the second conductive member 122 above the bracket 11, or may be formed separately on the bracket 11.

First, descriptions may be made of a case in which the first pressure sensor 120a and the second pressure sensor 120b are formed on the second conductive member 122.

That is, elastic supports 127 may be provided between the bracket 11 and the display panel 110 at the opposite sides of the pressing sensor unit 120, and between the opposite elastic supports 127, and the conductive member 122 may be mounted on the top face of the bracket 11. The elastic support member 129 may be provided between the second conductive member 122 and the display panel 110 at a central portion above the second conductive member 122. Thus, a space, in which the first pressure sensor 120a is seated, may be provided at one side of the elastic support member 129, and a space, in which the second pressure sensor 120b is seated, may be provided at the other side of the elastic supporting member 129.

The first pressure sensor 120a is stacked at one side of the elastic support member 129. The first conductive member 121 and the sensor member 123 may be stacked between the rear face of the display panel 110 and a common second conductive member 122. The second pressure sensor 120b is stacked on the other side of the elastic member. The first conductive member 121 and the sensor member 123 may be stacked between the rear face of the display panel 110 and the common second conductive member 122.

Accordingly, when the position of the first pressure sensor 120a is pressed, the first pressure sensor 120a can sense the pressing, but the pressing signal applied to the second pressure sensor 120b may be limited by the elastic support member 129.

In addition, when the position of the second pressure sensor 120b is pressed, the second pressure sensor 120b can sense the pressing, but the pressing signal applied to the first pressure sensor 120a may be limited by the elastic support member 129.

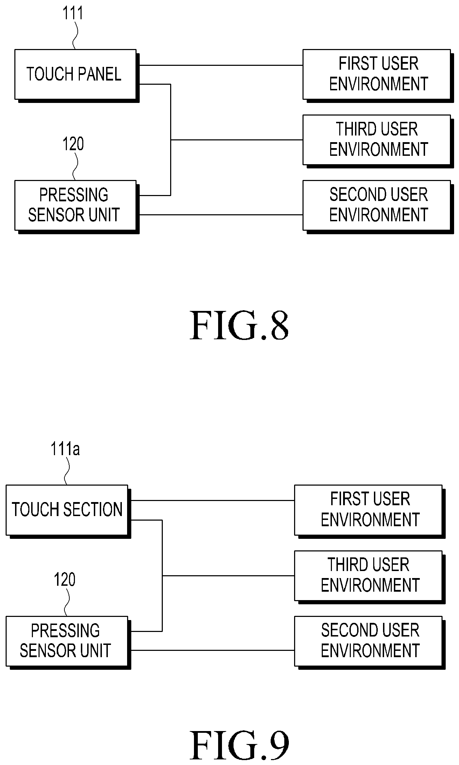

FIG. 8 is a block diagram schematically illustrating a user environment executed in the electronic device 10 according to input driving on the second screen region X2 in the electronic device 10 including the pressure-sensitive input device according to various embodiments of the present disclosure. FIG. 9 is a block diagram schematically illustrating a user environment executed in the electronic device 10 according to input driving on the opaque layer X3 in the electronic device 10 including the pressure-sensitive input device according to various embodiments of the present disclosure.

As described above, the pressing sensor unit 120 may be provided on the rear face of the second screen region X2 of the display panel 110, and may be provided on the rear face of the opaque layer X3 of the display panel 110.

First, when the pressing sensor unit 120 is provided on the rear face of the second screen region X2, at least three input methods may be implemented in the second screen region X2, so that the electronic device 10 is able to implement the user environment according to the three input methods.

For example, as the touch panel 111 is stacked on the second screen region X2, a first user input may be implemented through touch or proximity by the touch panel 111.

In addition, the pressing sensor unit 120 may be mounted on the rear face of the second screen region X2, so that when a predetermined force is applied to the second screen region X2 on which the pressing sensor unit 120 is mounted, a signal according to the pressing may be applied to the pressing sensor unit 120 and a second user input may be implemented according to the signal applied to the pressing sensor unit 120.

Also, the opaque layer X3 disposed around the screen section of the display panel 110, for example, the opaque layer X3 below the screen section, may be provided with an input device, such as the menu button described above. A touch section 111a may be provided to detect touch or proximity with respect to the position of the menu button so as to implement an input. The pressing sensor unit 120 may be mounted together with the touch section 111a. Of course, only the pressing sensor unit 120 may be provided, without being provided with the touch section 111a (see FIG. 8).

When the pressing sensor unit 120 is provided on the rear face of the opaque layer X3, at least three input methods may be implemented in the opaque layer X3, so that the electronic device 10 will be able to implement the user environment according to the three input methods.

For example, the opaque layer X3 may be mounted with the touch section 111a capable of implementing an input by detecting touch or proximity of an object, and as a result, a first user input can be implemented through the touch or proximity with respect to the touch section 111a.

In addition, the pressing sensor unit 120 may be mounted on the opaque layer X3, so that when a predetermined force is applied to the position of the opaque layer X3 on which the pressing sensor unit 120 is mounted, a signal according to the pressing may be applied to the pressing sensor unit 120 and the second user input may be implemented according to the signal applied to the pressing sensor unit 120.

In addition, the opaque layer X3 may be provided with the pressing sensor unit 120 and the touch section 111a may be stacked therewith. When the pressing sensor unit 120 and the touch section 111a are provided together, a signal according to proximity or touch with respect to the touch section 111a and a pressing signal with respect to the pressing sensor unit 120 may be received together, so that a third user input can be implemented.

As described above, in the case of the electronic device 10 including the pressure-sensitive input device according to an embodiment of the present disclosure, when the display panel 110 is provided to be bent to a side face of the electronic device 10, the display panel 110 may be disposed on the side face of the electronic device 10. Thus, the screen region may be enlarged, and input devices, such as a side button, may be implemented at a position overlapping the screen region. Since the input devices are not exposed to the surface of the electronic device 10, the input devices may increase the degree of freedom of design.

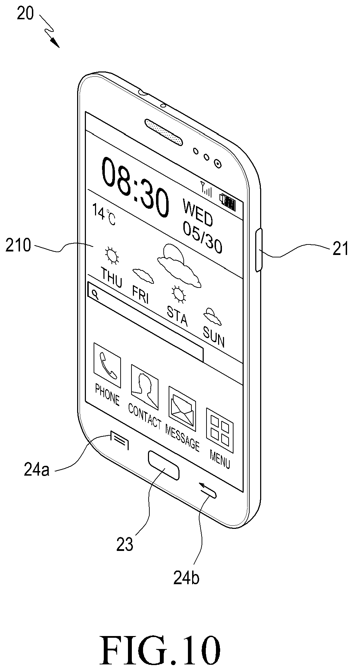

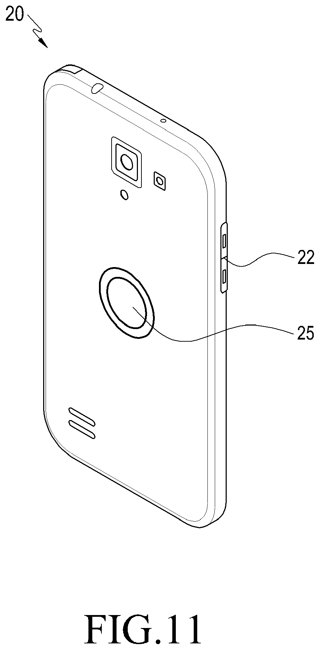

FIG. 10 is a view illustrating an input device 250 mounted on the front face and a side face in the electronic device 20 according to various embodiments of the present disclosure. FIG. 11 is a view illustrating an input device 250 mounted on the rear face and another side face in the electronic device 20 according to various embodiments of the present disclosure.

Referring to FIGS. 10 and 11, the electronic device 20 according to various embodiments of the present disclosure may be provided as a mobile communication terminal, and a cover may be formed in the electronic device 20 so as to form at least a portion of the outer surface of the electronic device 20. The cover may form the outer surface of the electronic device, and may include all components exposed to the outside (e.g., a display panel, a front case, a rear case, a side case, and a button cover).

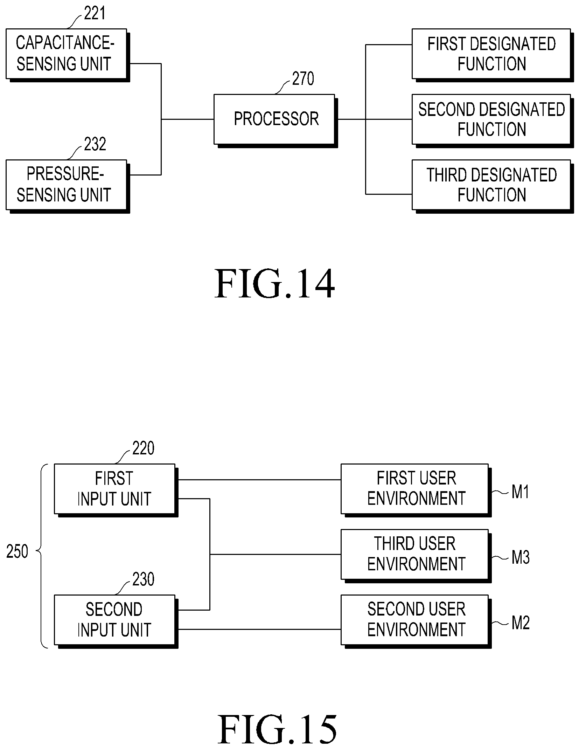

The input device 250 (see FIG. 15) according to an embodiment of the present disclosure may be formed adjacent to the cover of the electronic device 20. For example, the input device 250 according to various embodiments of the present disclosure may be disposed at a predetermined position on the cover, and the cover may be a constituent matter disposed on the input device, for example, on a first input unit 220 (see also FIG. 15) and a second input unit 230 (see also FIG. 15), and may be mounted on the electronic device 20.

As will be described below with reference to FIG. 15, the input device 250 according to one embodiment of the present disclosure may include the first input unit 220 and the second input unit 230.

The first input unit 220 may be provided in the electronic device 20, and may be provided so as to implement an input corresponding to a user input according to at least one of pressing and touching. For example, the first input unit 220 may include buttons provided on the front face, a side face, or the rear surface of the electronic device so as to implement an input (e.g., a display panel 210, a main button 23, touch buttons 24a and 24b, a power button 21, a volume button 22, and a rear button 25).

In addition, the second input unit 230 (also referred to as an "input device 250") may be provided at a position adjacent to the first input unit 220 or a position corresponding to the position of the first input unit 220, and may be provided to implement various inputs in response to a user input generated from the first input unit 220 and a user input generated from the second input unit 230. For example, the second input unit 230 may be provided on the rear face of the first input unit 220. That is, in order to implement an input in a method, which is the same as or different from the method of the buttons described above, the second input unit 230 may be provided on the rear faces of the first input unit, such as the display panel 210, the main button 23, the touch buttons 24a and 24b, the power button 21, the volume button 22, the rear button 25, etc. For example, the second input unit 230 may be mounted on the rear faces of the display panel 210 or touch buttons 24a and 24b, which sense proximity or touch, in order to sense a pressure, temperature, resistance according to proximity or touch, or the like. For example, the second input unit 230 may be mounted on the rear face of the main button 23, which implements an input as being pressed, the volume button 22, the power button 21, or the rear button 25, in order to sense the pressure, temperature, or resistance according to proximity or touch, or the like.

Unlike this, the second input unit 230 may be formed adjacent to a face of the cover adjacent to the first input unit 220. For example, the second input unit 230 may be mounted at a position adjacent to the display panel 210 or the touch buttons 24a and 24b, which sense proximity or touch (e.g., around the display panel 210, or around the touch buttons 24a and 24b) so as to sense the pressure, temperature, or resistance according to proximity or touch, or the like. In addition, for example, the second input unit 230 may be mounted around the main button 23, which implements an input as being pressed, around the volume button 22, around the power button 21, or around the rear button 25, in order to sense the pressure, temperature, or resistance according to proximity or touch, or the like.

For example, as illustrated in FIG. 10, the input device 250 (e.g., the first input unit 220) may be disposed at a position of the display panel 210 provided on the front face of the electronic device 20, and may be formed adjacent to the display panel 210 (See FIG. 10). For example, the display panel 210, which displays a screen, may be disposed on the front face of the electronic device 20. The display panel 210 may implement an input in various ways according to touch or proximity of an object onto the display panel 210 or according to the input device 250 according to various embodiments of the present disclosure, and may display an image according to a user environment. The display panel 210 may be disposed on at least one face of the main body of the electronic device 20, in which a touch panel (e.g., the touch panel 111) and a display panel (e.g., the display panel 112) for displaying a screen on one face of the touch panel 111 (e.g., the touch panel 111) may be stacked. The previous descriptions may apply in the detailed descriptions related to the structure of the display panel 210 according to various embodiments of the present disclosure and the detailed descriptions related to the touch panel (e.g., the touch panel 111) or the display panel (e.g., the display panel 112).

As the input device 250 according to various embodiments of the present disclosure, devices, which implement various types of inputs, may be mounted on or inside the display panel 210.

As described above, the display panel may be provided with an input device 250, such as a touch panel (e.g., the touch panel 111), which may sense proximity or touch so as to implement an input (here, the input device 250 corresponds to the "first input unit 220"). An input device 250, which implements an input according to touch, proximity, temperature, or pressure together with a touch panel (e.g., the touch panel 111) (here, the input device 250 corresponds to the "second input unit 230") may be mounted on the rear face of the touch panel 111 or around the touch panel 111.

In addition, in the input device 250 according to various embodiments of the present disclosure, devices, which implement various types of inputs, may be mounted on a peripheral case side (e.g., a bezel region where no screen is displayed on the front face of the electronic device) or a side case side of the display panel 250 (see FIGS. 10 and 11).

For example, the input device 250 (e.g., the first input unit 220) may be provided as the main button 23, which may implement a physical input at the lower side of the periphery of the display panel 210, and touch buttons 24a and 24b, which are capable of implementing a physical input or an input according to proximity, touch or temperature, or pressure, may be provided on opposite sides of the main button 23. In addition, the input device 250 (e.g., the second input unit 230) may be mounted on the rear surface or around the touch buttons 24a and 24b so as to implement an input according to touch, proximity, temperature, or pressure, together with the main button 23 or the touch buttons 24a and 24b.

In addition, the input device 250 (e.g., the first input 220) according to various embodiments of the present disclosure may be disposed at a predetermined position along the periphery of the side faces of the peripheral case of the display panel 210 (e.g., the electronic device 20). For example, a power button 21 for turning on/off the power of the electronic device 20 or switching the sleep mode of the electronic device 20 may be disposed at a predetermined position on a side face of the electronic device 20. Further, for example, a control button 22 for controlling the volume, controlling the movement of a page, or controlling the brightness of the screen may be disposed on one side face and on the other side face of the electronic device 20. In addition, the input device 250 (e.g., the first input unit 220) may be provided on the rear face of the electronic device 20 as the rear button 25, which may implement a physical input or an input according to proximity, touch, temperature, or pressure. In addition, the input device 250 (e.g., the second input 230) may be mounted on the rear face or periphery of the rear button 25 so as to implement an input which is the same as that of the rear button 25 or another input (e.g., an input according to touch, proximity, temperature, or pressure).

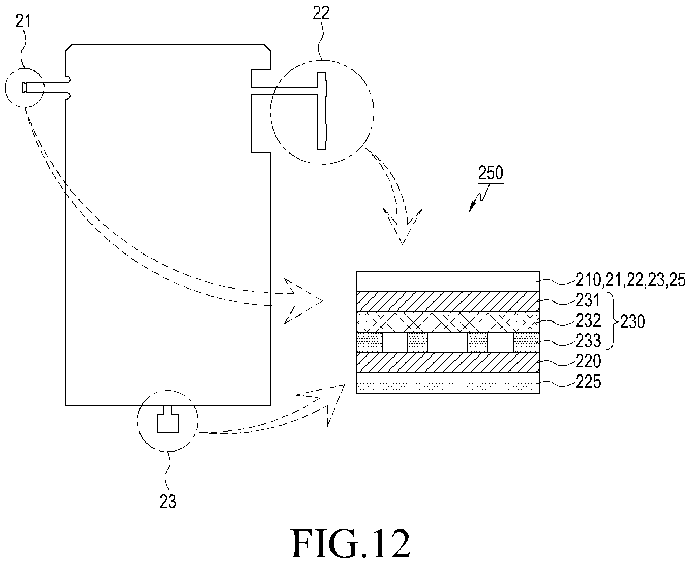

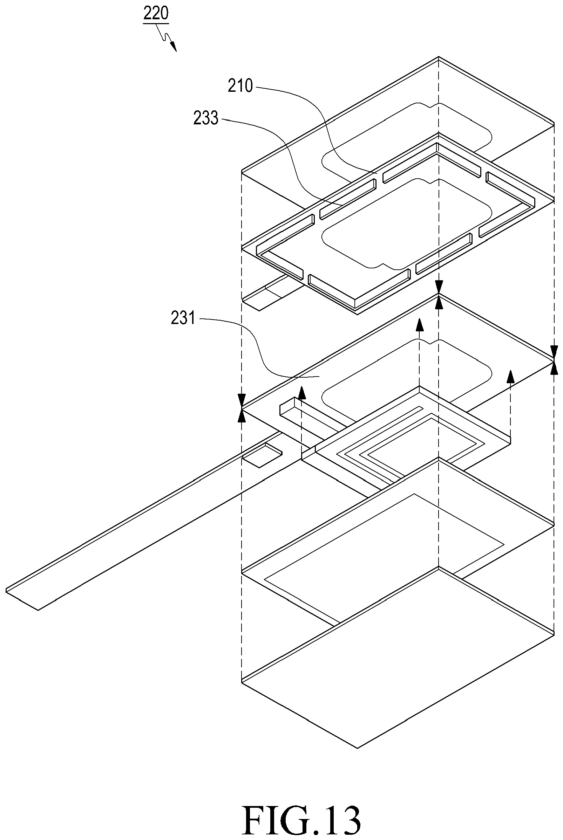

FIG. 12 is a view schematically illustrating a state of mounting an input device 250 inside the electronic device 20 according to various embodiments of the present disclosure. FIG. 13 is an exploded perspective view illustrating at least one input device 250 in the electronic device 20 according to various embodiments of the present disclosure.

Referring to FIGS. 12 and 13, the electronic device may be described with reference to a case in which the second input unit 230, the first input unit 220, and the bracket 225 are mounted in this order from a cover, such as the display panel 210, a front or side case, or a button cover, as an example. However, the above stacking order may be changed depending on the configuration and structure of the electronic device.

The first input unit 220 may be provided in the electronic device 20, and may be provided so as to implement an input corresponding to a user input according to at least one of pressing and touching.

For example, at least one face of the electronic device 20 may be mounted with a display panel 210 (see FIG. 10) that is capable of outputting a screen or implementing an input, and input buttons 21 (see FIG. 12), which implement an input to the electronic device 20 in response to a user input according to touch, proximity, or pressing, may be mounted on the periphery of the display panel 210 or a face that is different from that of the display panel 210. For example, touch buttons 24a and 24b may be provided around the display panel 210 on the same face as the display panel 210 so as to implement an input to the electronic device 20 in response to a user input by touch or proximity. In addition, a main button 23 may be provided that implements an input to the electronic device 20 in response to a user input by at least one of pressing, combined pressing and touch, and touch. In addition, a power button 21 or a volume button 22 may be provided that implements an input to the electronic device 20 in response to a user input by at least one of pressing, combined pressing and touch, and touch. In addition, a rear button 25 may be provided that implements an input to the electronic device 20 in response to a user input by at least one of pressing, combined pressing and touch, and touch.

The first input unit 220 according to various embodiments of the present disclosure may be provided as a capacitance-sensing unit 221.

According to an embodiment, the capacitance-sensing unit 221 may be formed adjacent to one face of the cover according to the position of the second input unit 230, or may be formed as a rear face of the first input unit 220.

According to an embodiment, the capacitance-sensing unit 221 may be provided to sense the variation of capacitance corresponding to a user input in response to the user input acquired through the cover. For example, when the user performs touch, proximity, or pressing input on the cover on which the second input unit 230 is positioned, the capacitance-sensing unit 221 may generate variation of capacitance as a user input, such as the touch, proximity, or pressing, is generated, and may sense the variation of capacitance caused thereby. The capacitance-sensing unit 221 may be configured to correspond to the second conductive member mentioned in a previous embodiment.

The capacitance-sensing unit 221 (also referred to as a "first sensing unit") may be used to confirm a position corresponding to a user input adjacent to the cover by being activated when situation information related to the electronic device 20 satisfies a first designated condition. In addition, the capacitance-sensing unit 221 may be used to confirm a pressure corresponding to a user input by being activated together with the pressure-sensing unit 232 to be described later when situation information related to the electronic device 20 satisfies a second designated condition.

The second input unit 230 may be provided at a position adjacent to the first input unit 220 or a position corresponding to the position of the first input unit 220, and may be provided to implement various inputs in response to a user input generated from the first input unit 220 and a user input generated from the second input unit 230. For example, the second input unit 230 may be provided on the rear face of the first input unit 220. Otherwise, the second input unit 230 may be formed around the first input unit 220.

The second input unit 230 may include a pressure-sensing unit 232 (also referred to as a "second sensing unit") and a spacer unit 233 (also referred to as a "spacer layer" and hereinafter referred to as a "spacer unit"), a coupling member, and the like. In addition, the second input unit may include a processor 270 (see FIG. 14) capable of implementing a user input corresponding to the input sensing of the first input unit 220 and the second input unit 230.

When situation information satisfying designated conditions is input to the input device 250 including the first input unit 220 and the second input unit 230, at least one of the capacitance-sensing unit 221 corresponding to the first input unit 220 and the pressure-sensing unit 232 of the second input unit 230 may be activated to perform a designated function.

The pressure-sensing unit 232 may be formed adjacent to one face of the capacitance-sensing unit 221. The pressure-sensing unit 232 may be selectively activated based on a user input or situation information for the electronic device 20.

According to an embodiment, the situation information may be determined according to an application that is being executed in the electronic device 20. For example, when the application, which is being executed in the electronic device 20, is an application related to pressure sensing, the electronic device 20 may perform at least pressure sensing and touch sensing simultaneously.

According to an embodiment, the situation information may be determined based on a battery level or a charging status of the electronic device 20. For example, when the state of charge of the battery of the electronic device 20 is equal to or lower than a predetermined level, the pressure sensing period or the touch period of the electronic device 20 may be adjusted according to the situation information.

According to an embodiment, the situation information may include a sleep mode, a deep sleep mode, or the like of the electronic device 20. For example, when the electronic device 20 operates in the sleep mode or the deep sleep mode, the operation related to the pressure or the touch of the electronic device 20 may be controlled.

In addition, the pressure-sensing unit 232 may be provided to sense the variation of pressure corresponding to the user input. For example, the pressure-sensing unit 232 may be activated as the user's touch, proximity, or pressing on the cover, or may be activated based on the situation information on the electronic device 20. When a user input is generated on the activated pressure-sensing unit 232 in response to a pressure, such as the user's touch or pressing, the variation of pressure is generated in the pressure-sensing unit 232 as the user input such as the pressure is generated, and the variation of pressure change caused thereby may be sensed. The pressure-sensing unit 232 may be configured to correspond to the first conductive member and the sensor member described in the foregoing embodiments.

The pressure-sensing unit 232 may be used to confirm a pressure corresponding to a user input by being activated together with the above-described capacitance-sensing unit 221 when situation information related to the electronic device 20 satisfies the second designated condition.

The spacer unit 233 (also referred to as a "spacer layer") may be provided to fix or elastically support the second input unit 230 when the second input unit 230 is stacked. For example, the spacer unit 233 may be disposed between the capacitance-sensing unit 221 and the pressure-sensing unit 232 so as to fixedly space the capacitance-sensing unit 221 and the pressure-sensing unit 232 apart from each other. The spacer unit 233 may be made of a silicon material or a urethane material.

The capacitance-sensing unit 221 and the pressure-sensing unit 232 according to various embodiments of the present disclosure may be switched at the stacked position. For example, when the input device 250 is sequentially stacked on one face of the cover, or when the input device 250 is formed on the rear face of the first input unit 220, such as the touch buttons 24a and 24b, the capacitance-sensing unit 221 is stacked from on face of the cover or the touch buttons 24a and 24b, and the pressure sensing part 232 may be stacked on the rear face of the capacitance-sensing unit 221. Unlike this, the pressure-sensing unit 232 may be stacked from one face of the cover or the touch buttons 24a and 24b, and the capacitance-sensing unit 221 can be stacked on the rear face of the pressure-sensing unit 232. This may be the same as the case where the positions of the first conductive member and the second conductive member including the sensor members may be variable in the above embodiments.

FIG. 14 is a block diagram schematically illustrating an operation according to the driving of a second input unit 230 in the electronic device 20 according to various embodiments of the present disclosure. FIG. 15 is a block diagram schematically illustrating an operation according to the driving of an input unit 250 in the electronic device 20 according to various embodiments of the present disclosure.

Referring to FIGS. 14 and 15, a processor 270 may be provided to perform a control such that the designated functions are performed according to the activation of at least one of the capacitance-sensing unit 221 and the pressure-sensing unit 232.

When the situation information related to the electronic device 20 satisfies the first designated condition, the capacitance-sensing unit 221 may be activated and the capacitance-sensing unit 221 may sense the variation of capacitance generated according to the user input. The processor 270 may confirm the position corresponding to the user input adjacent to the cover according to a value sensed by the capacitance-sensing unit 221, and may perform the first designated function based at least on the position.

Further, when the situation information related to the electronic device 20 satisfies the second designated condition, the capacitance-sensing unit 221 and the pressure-sensing unit 232 may be activated. The activated capacitance-sensing unit 221 may sense the variation of capacitance generated according to a user input, and the activated pressure-sensing unit 232 may sense the variation of pressure according to the user input. The processor 270 may confirm the pressure corresponding to the user input using values sensed by the capacitance-sensing unit 221 and the pressure-sensing unit 232, and may perform the second designated function based at least on the pressure.

In addition, the first designated condition may be set so as to perform the third designated function using simultaneously the capacitance-sensing unit 221 and the pressure-sensing unit 232 in at least a part of a predetermined time period.

For example, the third designated function may be set so as to perform a UX control (user experience control), such as a menu control, a volume control, or an application control, based on the pressure.

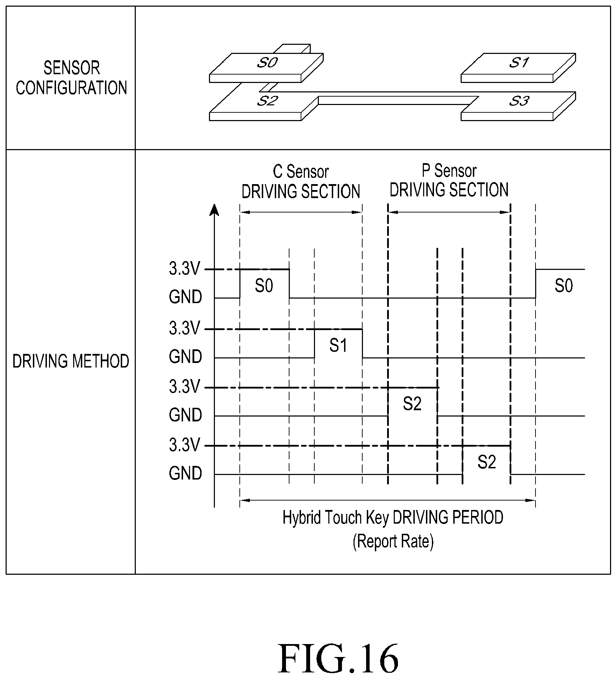

FIG. 16 is a view schematically illustrating an input device and a timing chart of the input device 250 according to a user input in the electronic device 20 according to various embodiments of the present disclosure.

Referring to FIG. 16 (refer to FIGS. 12 to 15 as well), when a user input is generated as the user's touch, proximity, or pressing on the input device 250, and the user input satisfies the first designated condition, the capacitance-sensing unit 221 may be activated, and may confirm the position corresponding to the user input. In addition, the electronic device 20 may perform a first designated function based on the position detected by the capacitance-sensing unit 221. For example, the electronic device 20 may grasp the touch position of the user and may perform an operation at the corresponding position.

According to an embodiment, when a user input is generated as the user's touch, proximity, or pressing on the input device 250, and the user input satisfies the second designated condition, the capacitance-sensing unit 221 and the pressure-sensing unit 232 may be activated. Accordingly, the pressure corresponding to the user input may be confirmed using the change value of the capacitance, which is changed based on the value of the capacitance generated between the capacitance-sensing unit 221 and the pressure-sensing unit 232, and the electronic device 20 may perform the second designated function based on a pressure value detected by the capacitance-sensing unit 221 and the pressure-sensing unit 232.

According to an embodiment, the pressure measurement may also be performed by a method other than a capacitance-based measurement method. For example, the pressure may be measured using a pressure sensor capable of sensing the force of the user.

The input device 250 provided as described above may implement a first user input M1 through an input value detected according to the driving of the first input unit 220. In addition, a second user input M2 may be implemented through sensing values detected by the capacitance-sensing unit 221 and the pressure-sensing unit 232.

In addition, a third user input M3 may be implemented by combining the input value of the first input unit 220 and the sensing values detected by the capacitance-sensing unit 221 and the pressure-sensing unit 232.

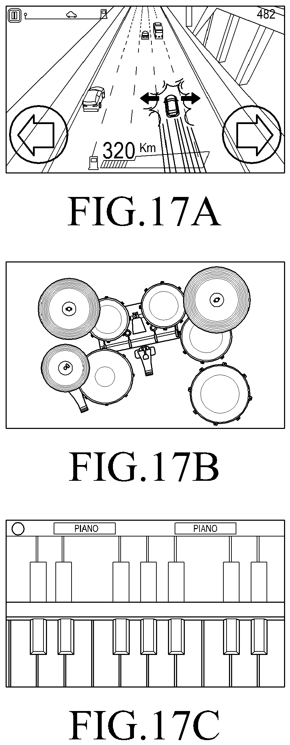

FIGS. 17 to 31 are a view illustrating embodiments, in which various functions according to an input device 250 are implemented in the electronic device 20 according to various embodiments of the present disclosure.

Referring to FIGS. 17 to 31, the second input unit 230 according to various embodiments of the present disclosure may be disposed at various positions. For example, the second input unit 230 may be disposed on the rear face of the display, more specifically, the screen region so as to implement an input according to the touch of the second input unit 230, in addition to an input according to the touch of the display (which may correspond to the first input unit 220), so that the second input unit 230 may implement various user inputs.

In addition, the second input unit 230 may be disposed on or in the vicinity of the rear face of the power button, the volume button, or the menu button (which may correspond to the first input unit 220), so that the second input 230 may implement various user inputs together with the input values of the first input unit 220, such as the power button, the volume button, or the menu button.

For example, many and various applications may use the strength and weakness of a pressure input to the second input unit 230, the length of the pressure, and the like. For example, an application of a musical instrument, such as a piano or a drum, may be utilized by using the strength and weakness of a pressure input to the second input unit 230 or the long length and short length of the input state (refer to FIG. 17). In addition, by using the distribution of pressure and the individual values of pressure in the second input unit 230, it is possible to utilize applications, such as an automobile racing application, a game application, and a percussion game. For example, in the state in which the user grasps the electronic device 20 with both hands, by sensing, through the second input unit 230, the pressure levels applied according to the pressing by the user's thumbs at the positions of the thumbs of two hands of the user, an action game, in which, for example, walking, running, jumping, or stopping is conducted, or the like may be utilized.

In addition, in the state in which the user grasps the electronic device 20 with both hands, by sensing, through the second input unit 230, the pressure levels applied according to the pressing by the user's thumbs at the positions of the thumbs of the two hands of the user such that acceleration may be adjusted through the pressure level of one thumb and braking may be adjusted through the pressure level of the other thumb. For example, when the right thumb applies the pressure, which is set to level 1, to the second input unit 230, the speed of a car may be accelerated, and when the right thumb applies the pressure, which is set to level 2, to the second input unit 230, the car may be rapidly accelerated. In addition, when the left thumb applies the pressure, which is set to level 1, to the second input unit 230, and the car may be stopped, and when the left thumb applies the pressure, which is set to level 2, the car may be rapidly stopped.

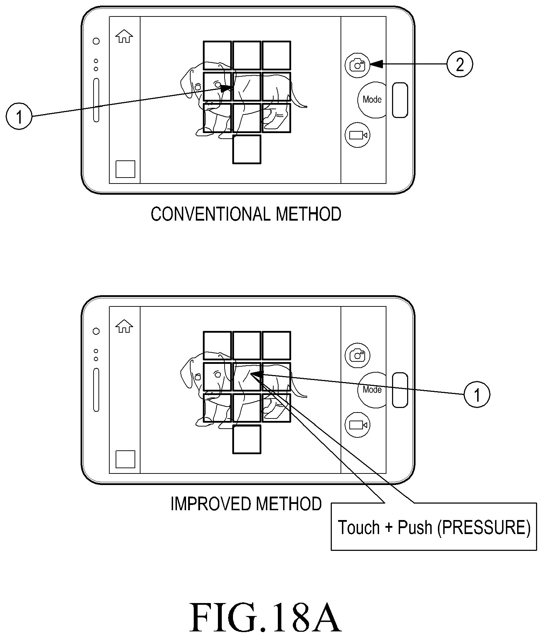

In addition, various operations related to a camera application may be implemented through the second input unit 230 (see FIGS. 18A to 18D).

For example, the user may perform simple photographing based on a focus desired by the user according to a touch, which is input to the first input unit 220, and a pressing pressure, which is input to the second input unit 230. When the user touches a desired focal point and applies a predetermined pressure to a desired focus (point) at the time of taking a close-up photograph or photographing a person, it is possible to adjust the focus and to perform the photographing immediately (see FIG. 18A). That is, to date, when taking a close-up photograph or photographing a person, it has been necessary to perform touch according to the desired focus, to adjust the focus, and then touch the position of the photographing button at a separate position in order to take the photograph. However, in the electronic device 20 according to various embodiments of the present disclosure, when the user touches a desired point and applies a predetermined pressure thereto, it is possible to adjust the focus according to the touch of the point and to take the photograph immediately according to the pressing.

In addition, according to the touch, which is input to the first input unit 220 and the pressing, which is input to the second input unit 230, the user may execute simple mode switching of the camera (photographing mode switching of the cameras mounted on the front and rear sides of the electronic device 20).

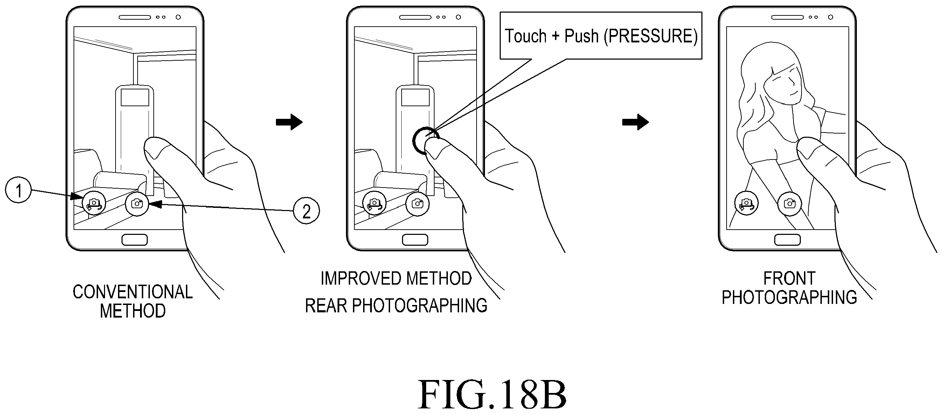

For example, by touching and pressing the front display, the driving of the camera mounted on the front and rear sides of the electronic device 20 can be automatically converted so as to perform screen switching. That is, a screen may be displayed such that imaging can be performed through one of the cameras mounted on the front and rear sides of the electronic device 20. To date, in order to perform photography using one of the cameras mounted on the front and rear sides and through the camera mounted on the other side, it has been necessary to execute a screen-switching mode button, which is separately displayed on the display (see FIG. 18B). In contrast, in the various embodiments of the present disclosure, when the screen displayed on the display is pressed, the screen switching mode can be immediately performed such that photographing can be performed in one of the cameras mounted on the front and rear sides and through the camera mounted on the other side. For example, when the user presses the screen during the rear photographing, the screen can be switched to the front photographing mode.

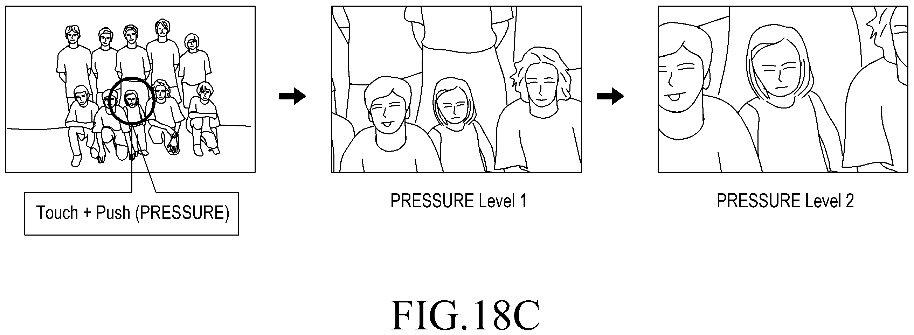

In addition, it is possible for the user to adjust the zoom-in/zoom-out of a desired point of a taken photograph according to a touch, which is input to the first input unit 220, and pressing and the intensity of the pressing, which are input to the second input unit 230 (see FIG. 18C).

By touching and pressing a desired point in a taken photograph, picture, or the like, it is possible to enlarge or reduce the desired point in the taken photograph, picture, or the like, and it is possible to adjust a range of enlargement or reduction according to the intensity of the pressure applied to the desired point. For example, when a desired person is to be enlarged in a taken photograph, the user may touch and press a portion in which the person exists so as to enlarge or reduce the portion (see FIG. 18C). For example, when the pressure is applied to a portion that is touched at the pre-set level 1, the indicated portion may be enlarged 1.5 times, and when the pressure is applied to a portion that is touched at the pre-set level 2, the indicated portion may be enlarged 2 times.

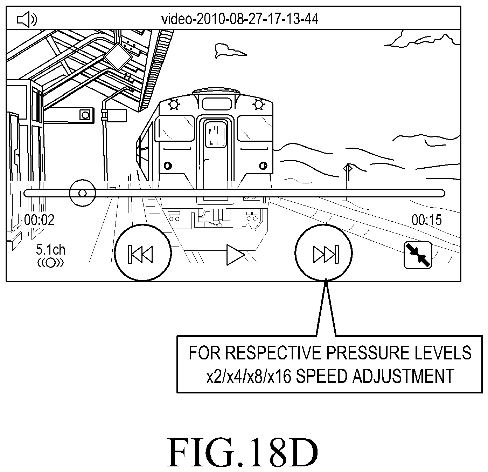

In addition, it is possible for the user to adjust a video playback speed according to a touch, which is input to the first input unit 220, and pressing and the intensity of the pressing, which are input to the second input unit 230 (see FIG. 18D).

For example, when the first button (rewind button) is touched while playing a video, rewinding may be performed, and when the rewind button is pressed and touched at the same time, the rewind speed may be adjusted to the 2-fold speed, the the-fold speed, the 8-fold speed, the 16-fold speed, or the like for respective pressure levels sensed by the second input unit 230. That is, when the pressure set to a level from the level 1 to the level 4 is sensed by the second input unit 230, it is possible to perform the rewind at a speed from the 2-fold speed to the 16-fold speed. In addition, when the second button (fast-rewind button) is touched while playing the video, fast rewinding may be performed, and when the fast-rewind button is pressed and touched at the same time, the fast-rewind speed may be adjusted to the 2-fold speed, the 4-fold speed, the 8-fold speed, the 16-fold speed, or the like for respective pressure levels sensed by the second input unit 230. That is, when the pressure set to a level from the level 1 to the level 4 is sensed by the second input unit 230, it is possible to perform the fast rewind at a speed from the 2-fold speed to the 16-fold speed.

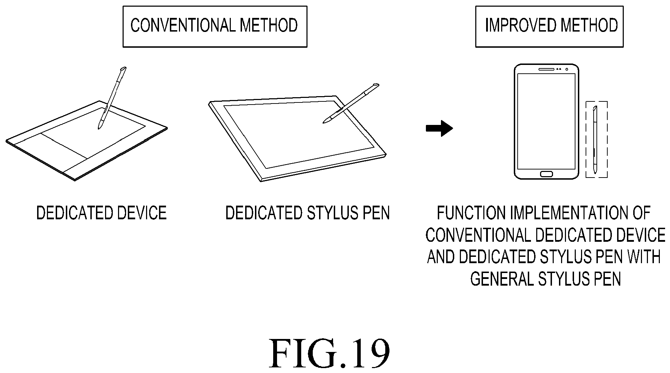

In addition, it is possible for the user to implement various inputs, which can be implemented by a high-sensitivity stylus pen on the display, according to a touch, which is input to the first input unit 220, and the pressing and the intensity of the pressing, which are input to the second input unit 230 (see FIG. 19).

For example, it is possible to implement pen-style writing inputs of various thicknesses or various types using a general stylus pen according to a touch and a pressing level on the display. That is, when the user inputs handwriting, a pattern, or the like at the pre-set level 1 using a general stylus pen, the input of a letter, pattern, or the like having a thickness according to the level 1 can be implemented, and when handwriting or a pattern is input at the level 2, an input of a letter, a pattern, or the like, having a thickness which is thicker than, for example, that of the level 1, can be implemented.

Unlike this, when handwriting or a pattern is input at the pre-set level 1 using a stylus pen, it is possible to implement an input of a letter, pattern, or the like written by, for example, a pencil- or ballpoint pen-type instrument, and when handwriting or a pattern is input at the level 2, it is possible to implement an input of a letter, pattern, or the like written by, for example, a hair pencil-type instrument.

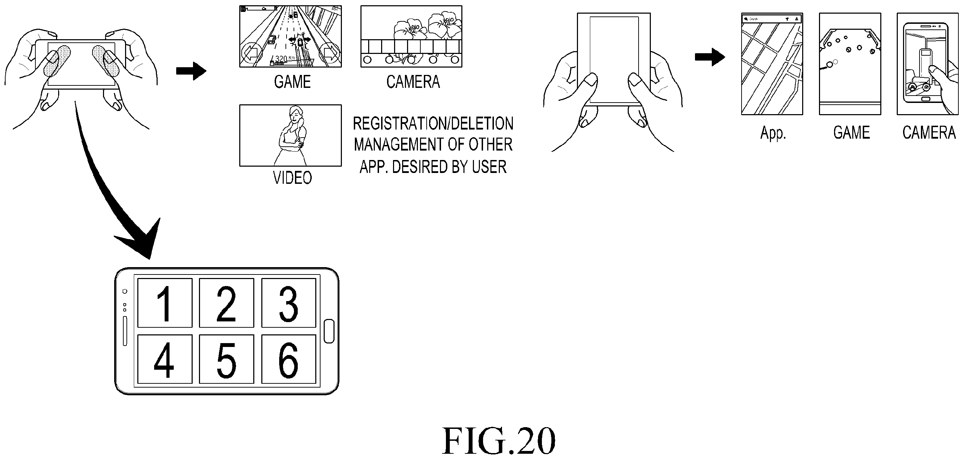

In addition, the user may implement simple mode switching according to a plurality of touches, which are input to the first input unit 220 and a touch and pressing and the number of times of pressing, which are input to the second input unit 230 (see FIG. 20).

That is, when two points at pre-set positions in the display are touched and pressed, the electronic device 20 may be implemented such that the two points can be distinguished from each other so as to execute a specific function. For example, in the case in which the electronic device 20 is implemented in a slim mode and the display is implemented as a black screen, when the user touches and presses the positions of Numbers 1 and 6 in the display, the electronic device 20 may operate in response thereto so as to directly execute a pre-set designated function, for example, a camera application or a map application, or to directly provide other pre-set applications.

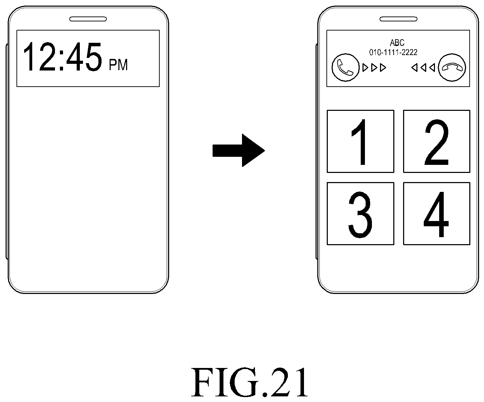

In addition, the operation mode in the state in which the electronic device 20 is covered may be improved according to pressing and the number of times of pressing, which are input to the second input unit 230 (see FIG. 21).

That is, when a call request is received by the electronic device 20 in the state in which the entire display face of the electronic device 20 is covered by a cover, if the user applies a pressure equal to or higher than a predetermined level to a volume button located on a side face of the electronic device 20 or a portion in which the second input unit 230 is mounted in the state of grasping the electronic device 20, the second input unit 230 may enable a call or a call rejection simultaneously with sensing the pressure. For example, when the user grasps the electronic device 20 in the state in which the display is covered with the cover, the side face, on which the second input unit 230 can be mounted, may be touched with the user's hand. Thus, when a call request is received by the electronic device 20, a pressure may be transmitted to the second input unit 230 when the user applies a force in the state of grasping the electronic device 20. Accordingly, when the user presses the electronic device 20 once in the state of grasping the electronic device 20, a pressure value corresponding to a single pressure may be detected by the second input unit 230, and the electronic device 20 may execute a designated function, which is one of, for example, a call and a call rejection. In addition, when the user presses the electronic device 20 twice in the state of grasping the electronic device 20, a pressure value corresponding to the pressure applied twice may be detected by the second input unit 230, and the electronic device 20 may execute a designated function, which is a remaining one of, for example, a call and a call rejection.

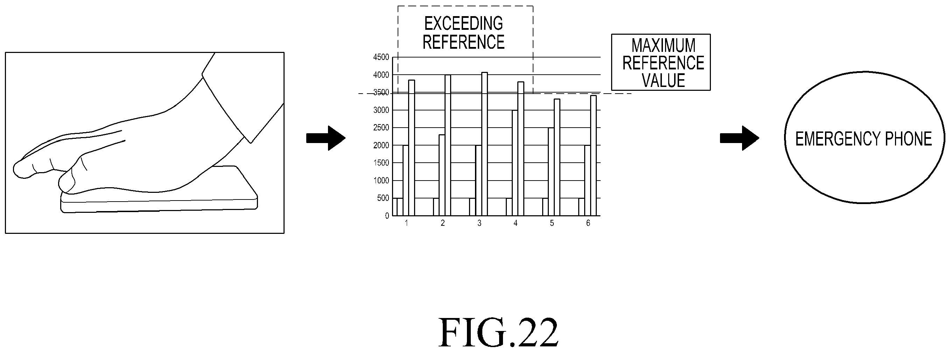

In addition, an emergency button or the like may be implemented according to the intensity of pressing or the number of times of pressing, which is input to the second input unit 230 (see FIG. 22).

That is, in the case in which an urgent event occurs to the user, for example, in the case in which the user keels over or falls and is injured so that the user cannot move his/her body, legs, or the like, or in the case in which an emergency, such as robbery, occurs, when the user applies a pressure equal to or higher than a predetermined pressure to the second input unit 230 or continuously applies a pre-set pressure two times or three times, an emergency number may be directly dialed to call for help.

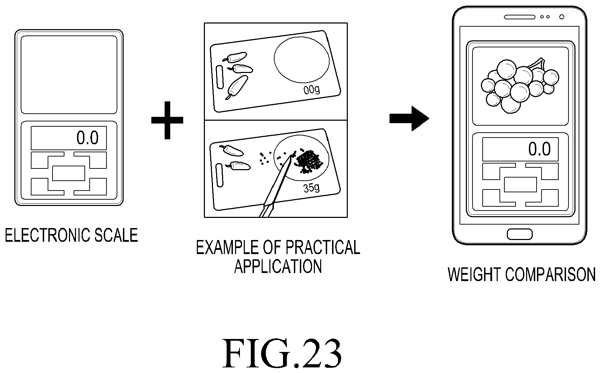

Also, weight may be measured according to the intensity of pressing, which is input to the second input unit 230 (see FIG. 23).

For example, in the case in which the user tries to measure the weight of an item, when the item is placed on a screen area, the second input unit 230 may sense a pressure corresponding to the weight of the item placed on the screen area, and may measure the weight of the item accordingly. For example, when rice, a side dish, or the like is placed on the electronic device 20, a user, who is on a diet or needs to adjust his/her diet due to diabetes or the like, may be informed of the weight of the rice, the side dish, or the like.

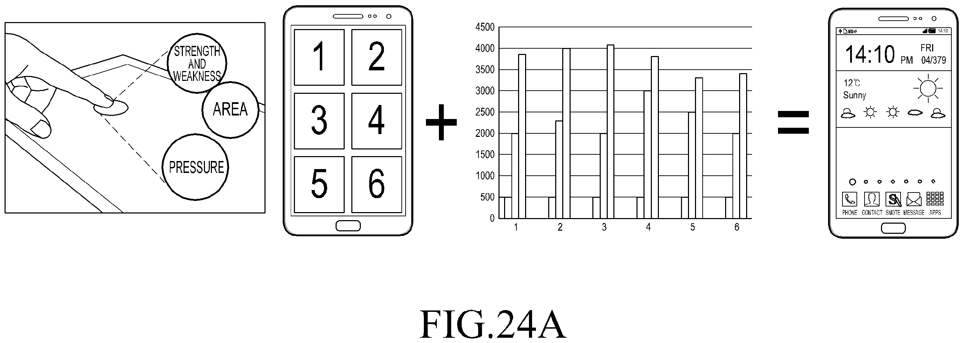

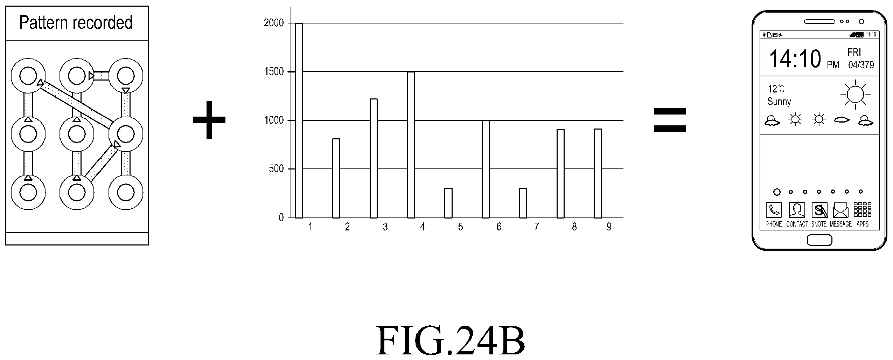

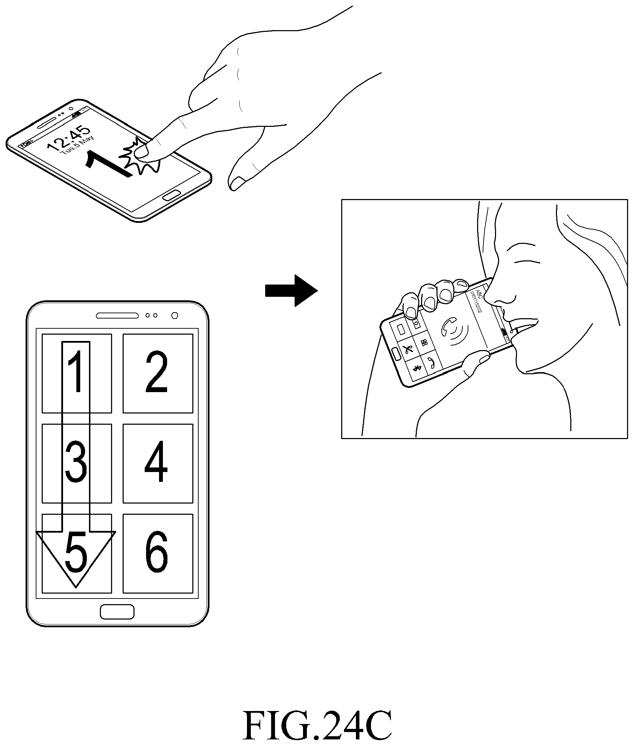

In addition, depending on a touch, which is input to the second input unit 230, and pressing and the intensity of the pressing, which are input to the second input unit 230, the electronic device 20 may be unlocked, a phone call may be directly made using a pre-set abbreviated number, or the security of a pattern lock may be strengthened (see FIGS. 24A, 24B, and 24C).

When the electronic device 20 is locked, the electronic device 20 may be unlocked by touching divisional sections or patterns in the screen area or by applying different pressures to the respective divisional sections or patterns in the screen area while touching the respective divisional sections or patterns in the screen area (see FIGS. 24A and 24B)

That is, for example, the user may divide a locking device into six sections, and may set different pressures for respective sections. Thus, when the electronic device 20 is in the locked state, the electronic device 20 can be released only when the different pressures, which have been pre-set by the user, are provided to the six respective divisional sections (see FIG. 24A).

In addition, when the locking device is set to be divided and released in a pattern manner, the user may form not only a release shape by connecting touches of the patterns, but also a lock release pattern shape together with the release shape by distinguishing the pressure levels for respective pattern points. Thus, the locking of the electronic device 20 can be released only when the pattern release shape is implemented not only by connecting the respective patterns in the state in which the electronic device 20 is locked, but also by implementing the pre-set pressure levels pre-set for the respective pattern points (see FIG. 24B). Therefore, the security can be strengthened in comparison with the locking of the existing electronic devices 20 because it is necessary to satisfy not only the touch, but also the pre-set pressure values.

In addition, the screen area may be provided such that the screen area may be divided into predetermined sections, the electronic device may be configured to be connected to a pre-set abbreviated number when each of the sections is pressed, or depending on sections, which are pressed while being touched, among the sections (FIG. 24C).

For example, the touch panel may be provided such that when the user presses the divided sections of Nos. 1, 3, and 5 on the screen area, which is divided into six sections, while touching the divided sections of Nos 1, 3, and 5, a phone call can be directly made with a pre-set abbreviated number.

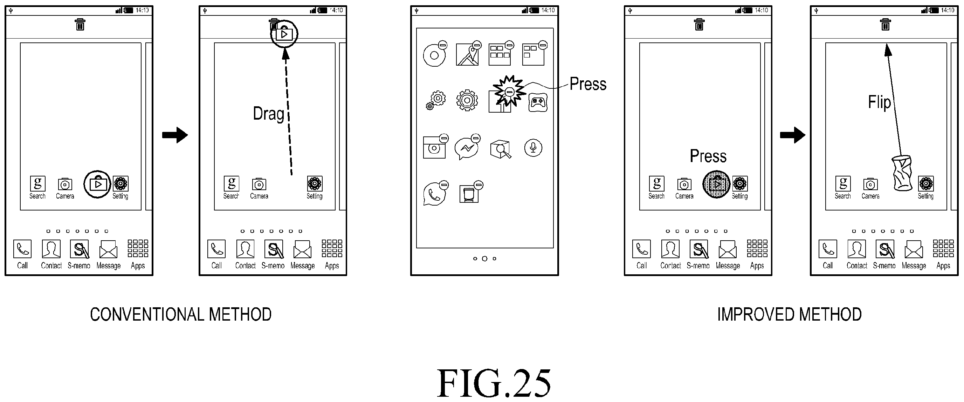

In addition, the screen area may be implemented such that an application icon can be moved or deleted according to pressing and the time of pressing, which are input to the second input unit 230 (see FIG. 25).

Application icons are arranged on the screen area in order to drive various functions of applications. Of the application icons, the user may delete undesired application icons, or may move certain application icons to another page or to a desired folder. When the user presses and drags an undesired application icon in the state of touching an undesired application icon in order to delete the undesired application icon, the undesired application icon can be moved directly to the recycle bin. To date, in order to delete an application icon, it has been necessary to keep touching the application icon for a predetermined period of time, and when the application icon wiggles due thereto, it is necessary to drag and move the application icon to the recycle bin. In contrast, the electronic device 20 according to the various embodiments of the present disclosure may be implemented such that when an application icon is pressed to the pre-set level 1 in the state of being touched, the application icon can be moved. The electronic device 20 according to the various embodiments of the present disclosure may be implemented such that when an application icon is pressed to the pre-set level 2 in the state of being touched, the application icon may be distorted (e.g., wiggling). The application icon prepared to be deleted may by directly deleted by dragging or flipping the application icon.

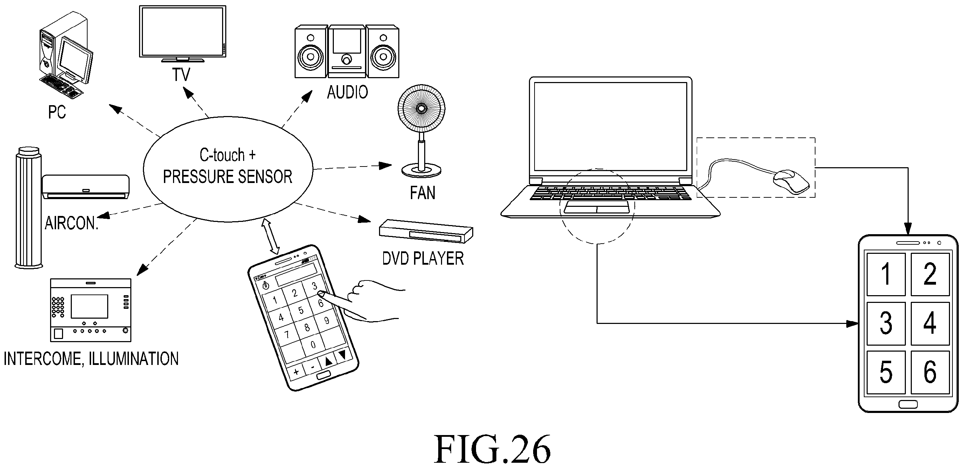

In addition, the electronic device 20 may be implemented such that the setting mode may be changed according to the simultaneous combination of a touch, which is input to the first input unit 220, and pressing, which is input to the second input unit 230 (see FIG. 26).

For example, the electronic device 20 may be implemented so as to control various external electronic devices 20. For example, external electronic devices 20, such as a TV, an audio device, a fan, an intercom, an illumination device, an air conditioner, a computer, and a notebook computer, may be controlled through the electronic device 20. To date, it has been difficult to control the other external electronic devices 20 while controlling the TV through the electronic device 20, or in order to change the setting of TV control, it has been necessary to perform a complicated process in which the TV control setting should be canceled and the state of the electronic device 20 should be changed to a state in which the external electronic devices 20 other than the TV can be controlled. On the other hand, in the case of the electronic device 20 according to the various embodiments of the present disclosure, the electronic device 20 can be used in a state in which the external electronic devices 20 other than a TV can be controlled directly by touching and pressing the screen area while the TV is being controlled through the electronic device 20.

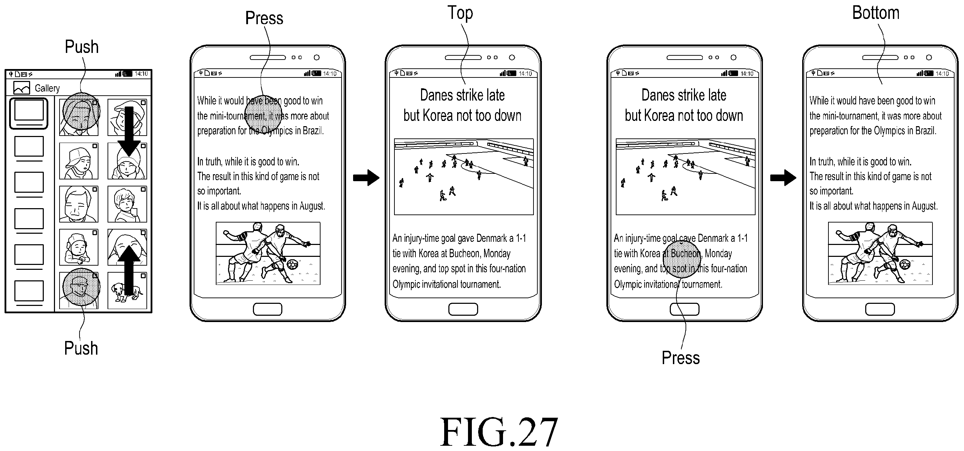

In addition, the electronic device 20 may be implemented such that scrolling and the moving speed or moving page of the scrolling can be adjusted according to a touch and a touch position, which are input to the first input unit 220 and pressing and the intensity of the pressing, which are input to the second input unit 230 (see FIG. 27).

For example, in the case in which the user scrolls through photographs in order to find a desired one of the photographs, when the user touches and presses one of the first and second input units, the photographs may be strolled in a pre-set direction according the touch of the first input unit or the second input unit, and the scrolling speed of the photographs displayed on the screen or the number of scrolled pages may be adjusted according to the intensity of the pressure applied to one of the first and second input units. For example, the electronic device may be implemented such that when one of the first and second input units is pressed to a pre-set level 1, movement through five rows of photographs may be performed, when one of the first and second input units is pressed to a pre-set level 2, movement through ten rows of photographs may be performed, and when one of the first and second input units is a pressed level 3, movement to the photographs on the first or last page may be performed.

In addition, when the user touches and presses one of the first and second input units according to an input position of the screen when the user reads an Internet news or a web-book or checks an SNS message or the like, the contents of the Internet news, the web-book, or the SNS may be scrolled in a predetermined direction according to a touch of the first portion or the second portion, and the moving speed or the like of the contents of the Internet news, the web-book, or the SNS displayed on the screen may be adjusted according to the intensity of the pressing applied to one of the first and second input units. For example, when the first or second input unit is pressed to the pre-set level 1, scrolling through a half screen of the display may be performed, when the first or second input unit is pressed to the pre-set level 2, the screens in the display may be moved or turned over one by one, and when the first or second input unit is pressed to the pre-set level 3, scrolling to the contents on the first screen or the last screen may be performed.

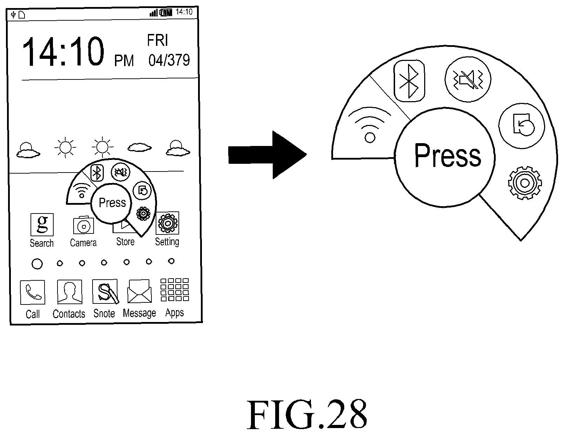

In addition, depending on a touch input to the first input unit 220 and the pressing input to the second input unit 230, a command application pop-up window may be executed and maintained or an executed command application pop-up window may be deleted so as not be executed (see FIG. 28).

When the front face of the display of the electronic device 20 is pressed, the command application pop-up window may be opened and when the pressure is released, the command application pop-up window may remain in the state of being executed in the display. Therefore, the user may execute a command through a command application executed on the display.

In addition, when the user touches the command application pop-up window and applies a pre-set pressure to the command application pop-up window, the command application pop-up window, which has been executed, may disappear, and the user may not use the command application pop-up window.

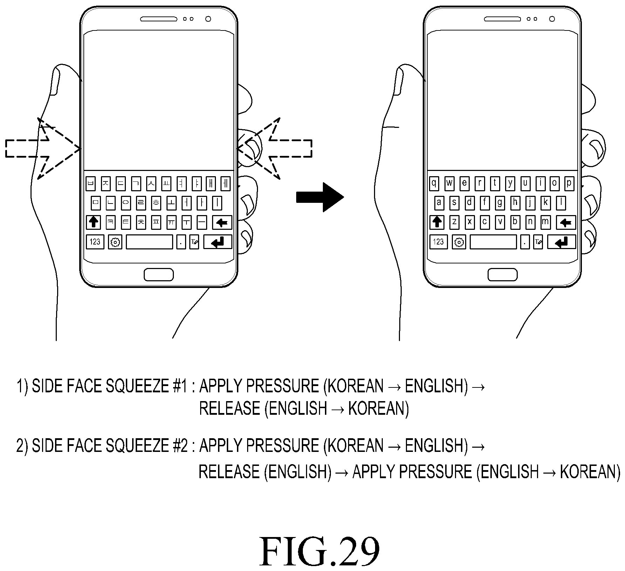

In addition, a keyboard conversion function may be implemented depending on pressing, which is input to the second input unit 230 (see FIG. 29).

When the user implements an input using a keyboard, which appears in a region of the screen area, it is necessary to change a Korean keyboard to an English keyboard, a symbol keyboard, or the like. At this time, when the user grasps and presses both side faces of the electronic device 20, the second input units 230 provided on both sides may be pressed so that the pressure can be detected. The electronic device 20 may be set to change the keyboard when the pre-set mode is in the pressed state or non-pressed state. When the user maintains the state of grasping the both side faces of the electronic device 20, the second input unit 230 detects the pressure, and the keyboard appearing on the screen of the electronic device 20 may be changed to a keyboard other than the Korean keyboard, for example, the English keyboard or the symbol keyboard, whereas when the user releases the grasping state, the keyboard can be changed to the original Korean keyboard. Unlike this, the electronic device 20 may be set to change the keyboard as the pre-set mode of the electronic device 20 is changed from the pressed state to the released state and again to the pressed state. When the user grasps both side faces of the electronic device 20 in the state of using, for example, the Korean keyboard, the pressure is applied to the second input unit 230, and thus the Korean keyboard is changed to a keyboard other than the Korean keyboard, whereas when the user releases the grasping, the keyboard may be changed to a keyboard other than the Korean keyboard, for example, the English keyboard. In addition, when the user grasps both side faces of the electronic device 20 once again, the pressure is applied to the second input unit 230, and the keyboard may be changed to a keyboard other than the English keyboard, for example, a symbol keyboard.

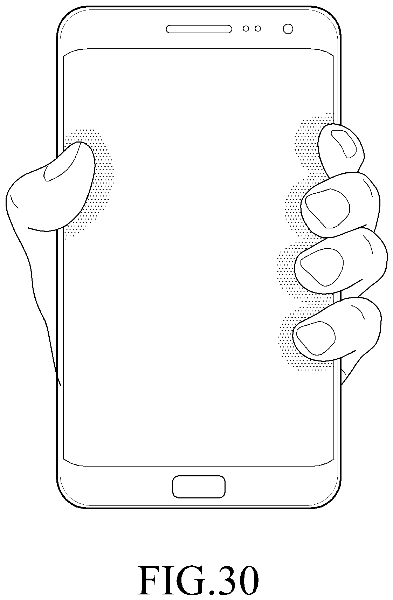

In addition, since a touch is input to the first input unit 220 and pressing is input to the second input unit 230, it is possible to prevent a malfunction due to an erroneous touch or erroneous pressing (see FIG. 30).

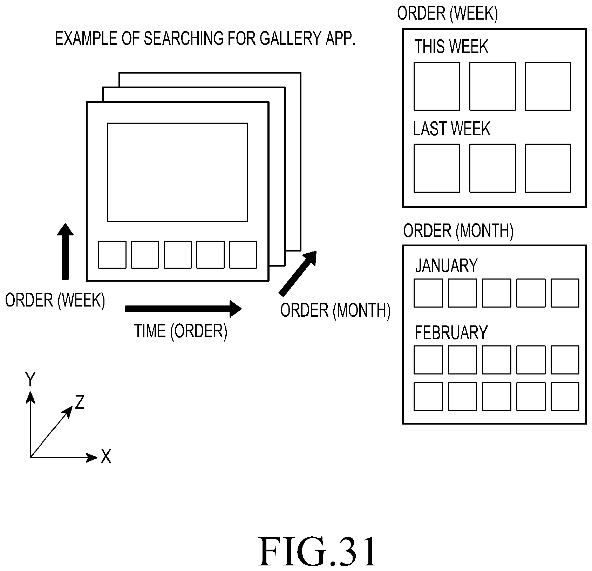

In addition, various inputs may be implemented through hovering in addition to the touch, which is input to the first input unit 220, and pressing, which is input to the second input unit 230 (see FIG. 31).

For example, a force applied in the direction perpendicular to the cover according to the user's input may be proportional to the pressure and time. At a position spaced apart from the cover within a predetermined distance, even if the cover is not directly touched, it is possible to implement various inputs by sensing a distance to the cover or a force applied in a direction perpendicular to the cover.

For example, the user's input may be generated on a plane (x-y plane) that is the same as the cover or on a plane (x-z plane) that is perpendicular to the cover. For example, in the case of a calendar in which a task to be performed is being created or has been created, among the user's inputs generated in the plane that is the same as the cover and the inputs in the y-axis direction may be displayed for weekly diary of every week, the inputs in the x-axis direction may be displayed in the order of respective days in one week. In addition, the user's inputs generated in the axis perpendicular to the cover may be displayed in the order of respective months.

Hereinafter, descriptions will be made on an electronic device according to various embodiments with reference to the accompanying drawings. In the present disclosure, the term "user" may refer to a person who uses an electronic device or a device that uses an electronic device (e.g., an artificial intelligence electronic device).

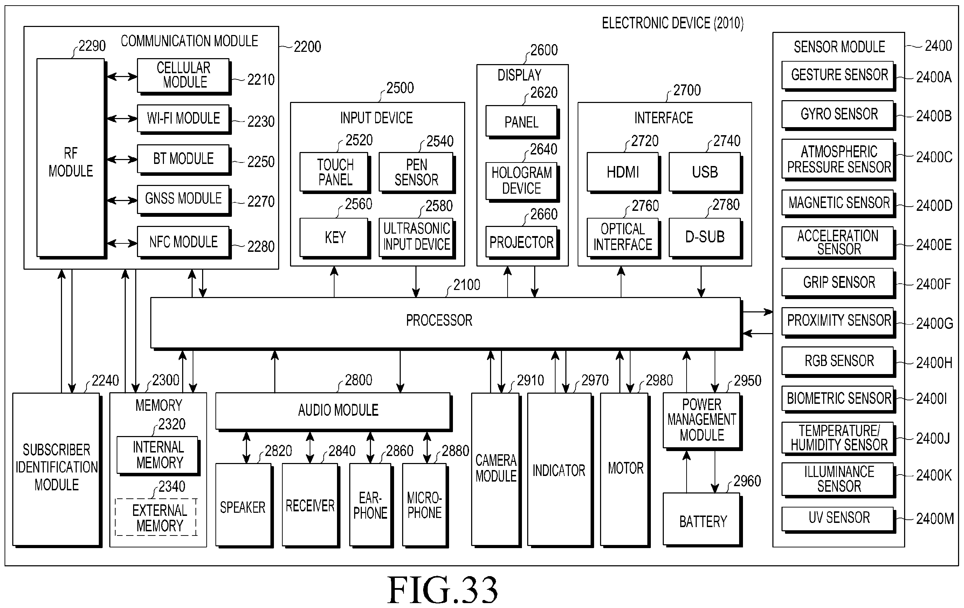

An electronic device 1010 within the network environment 1000, in various embodiments, will be described with reference to FIG. 33. The electronic device 1010 may include a bus 1100, a processor 1200, a memory 1300, an input/output interface 1500, a display 1600, and a communication interface 1700. In a certain embodiment, at least one of the above-mentioned components may be omitted from the electronic device 1010 or the electronic device 1010 may additionally include other components.

The bus 1100 may include, for example, a circuit that interconnects the above-mentioned components 1100 to 1700 and transmits communication (e.g., a control message and/or data) between the components.

The processor 1200 may include one or more of a Central Processing Unit (CPU), an Application Processor (AP), and a Communication Processor (CP). The processor 1200 may execute, for example, an arithmetic operation or data processing that is related to a control and/or communication of one or more other components of the electronic device 1010.

The memory 1300 may include a volatile memory and/or a non-volatile memory. The memory 1300 may store, for example, commands or data that are related to one or more other components of the electronic device 1010. According to one embodiment, the memory 1300 may store software and/or a program 1400. The program 1400 may include, for example, a kernel 1410, a middleware 1430, an Application Programming Interface (API) 1450, and/or an application program (or an "application") 1470. At least one of the kernel 1410, the middleware 1430, and the API 1450 may be referred to as an Operating System (OS).

The kernel 1410 may control or manage system resources (e.g., the bus 1100, the processor 1200, or the memory 1300) that are used for executing operations or functions implemented in the other programs (e.g., the middleware 1430, the API 1450, or the application programs 1470). In addition, the kernel 1410 may provide an interface that allows the middleware 1430, the API 1450, or the application programs 1470d to access individual components of the electronic device 1010 so as to control or manage the system resources.

The middleware 1430 may play an intermediary role such that, for example, the API 1450 or the application 1470 may communicate with the kernel 1410 so as to exchange data.

In addition, the middleware 1430 may process one or more task requests which are received from the applications 1470, according to priority. For example, the middleware 1430 may assign the priority to be capable of using a system resource of the electronic device 1010 (e.g., the bus 1100, the processor 1200, or the memory 1300) to at least one of the application programs 1470. For example, the middleware 1430 may perform scheduling, load balancing, or the like for the one or more task requests by processing the one or more requests according to the assigned priority.

The API 1450 is, for example, an interface that allows the applications 1470 to control functions provided from the kernel 1410 or the middleware 1430, and may include, for example, one or more interfaces or functions (e.g., commands) for a file control, a window control, an image processing, or a character control.

The input/output interface 1500 may serve as an interface to transmit commands or data, which are entered from, for example, a user or any other external device, to the other component(s) of the electronic device 1010. Also, the input/output interface 1500 may output commands or data, which are received from the other component(s) of the electronic device 1010, to the user or the other external device.

The display 1600 may include, for example, a Liquid Crystal Display (LCD), a Light-Emitting Diode (LED) display, an Organic Light-Emitting Diode (OLED) display, or a MicroElectroMechanical System (MEMS) display, or an electronic paper display. The display 1600 may display various contents (e.g., text, image, video, icon, or symbol) to, for example, the user. The display 1600 may include a touch screen, and may receive a touch input, a gesture input, a proximity input, or a hovering input that is made using, for example, an electronic pen or a part of the user's body.

The communication interface 1700 may set, for example, communication between the electronic device 1010 and an external device (e.g., a first external electronic device 1020, a second external electronic device 1040, or a server 1060). For example, the communication interface 1700 may be connected with a network 1620 through wired or wireless communication so as to communicate with the external device (e.g., the second external electronic device 1040 or the server 1060).

The wireless communication may use at least one of, for example, Long-Term Evolution (LTE), LTE Advance (LTE-A), Code Division Multiple Access (CDMA), Wideband CDMA (WCDMA), Universal Mobile Telecommunication System (UMTS), Wireless Broadband (WiBro), or Global System for Mobile communication (GSM), as a cellular communication protocol. In addition, the wireless communication may include, for example, short range communication 1640. The short-range communication 1640 may include at least one of, for example, Wireless Fidelity (WiFi), Bluetooth, Near Field Communication (NFC), and Global Navigation Satellite System (GNSS). GNSS may include, for example, at least one of Global Positioning System (GPS), Global Navigation Satellite System (Glonass), Beidou Navigation Satellite System (hereinafter, "Beidou"), Galileo, and the European global satellite-based navigation system, according to, for example, a use area or band width. Herein, "GPS" may be interchangeably used with "GNSS" below. The wired communication may use at least one of, for example, Universal Serial Bus (USB), High Definition Multimedia Interface (HDMI), Recommended Standard 232 (RS-232), and Plain Old Telephone Service (POTS). The network 1620 may include a telecommunication network, for example, at least one of a computer network (e.g., LAN or WAN), the internet, and a telephone network.

Each of the first and second external electronic devices 1020 and 1040 may be the same type as or different from the electronic device 1010. According to one embodiment, the server 1060 may include a group of one or more servers. According to various embodiments, all or some of the operations to be executed by the electronic device 1010 may be executed by another electronic device or a plurality of other electronic devices (e.g., the electronic devices 1020 and 1040), or the server 1060. According to one embodiment, in the case where the electronic device 1010 should perform a certain function or service automatically or by a request, the electronic device 1010 may request some functions or services that are associated therewith from the other electronic devices (e.g., the electronic devices 1020 and 1040 or the server 1060), instead of, or in addition to, executing the functions or service by itself. The other electronic devices (e.g., the electronic devices 1020 and 1040 or the server 1060) may execute the requested functions or additional functions, and may deliver the results to the electronic device 1010. The electronic device 1010 may provide the requested functions or services by processing the received results as they are or additionally. For this purpose, for example, a cloud computing technique, a distributed computing technique, or a client-server computing technique may be used.

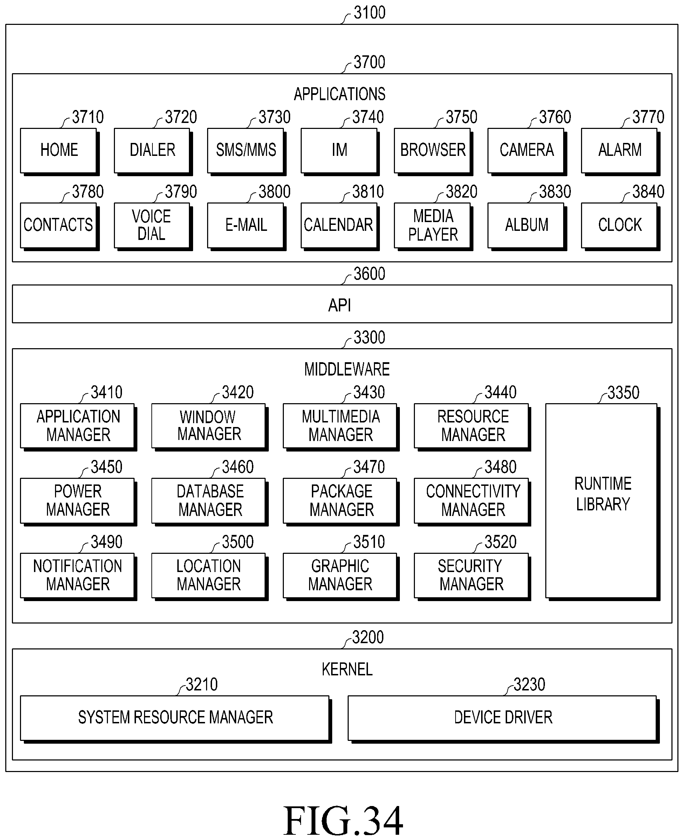

FIG. 34 is a block diagram of an electronic device 2010 according to various embodiments. The electronic device 2010 may include, for example, the whole or a portion of the electronic device 1010 illustrated in FIG. 33. The electronic device 2010 may include at least one processor (e.g., an Application Processor (AP)) 2100, a communication module 2200, a subscriber identification module 2240, a memory 2300, a sensor module 2400, an input device 2500, a display 2600, an interface 2700, an audio module 2800, a camera module 2910, a power management module 2950, a battery 2960, an indicator 2970, and a motor 2980.

The processor 2100 may drive, for example, an operating system or an application program so as to control a plurality of hardware or software components connected thereto, and may also perform various data processing and arithmetic operations. The processor 2100 may be implemented by, for example, a System-on-Chip (SoC). According to one embodiment, the processor 2100 may further include a Graphic Processing Unit (GPU) and/or an image signal processor. The processor 2100 may include at least some components (e.g., a cellular module 2210) among the components illustrated in FIG. 34. The processor 2100 may load a command or data received from at least one of the other components (e.g., a non-volatile memory) in a volatile memory to process the command and data, and may store various data in a non-volatile memory.

The communication module 2200 may have a configuration that is the same as or similar to the communication interface 1700 of FIG. 33. The communication module 2200 may include, for example, a cellular module 2210, a WiFi module 2230, a Bluetooth module 2250, a GNSS module 2270 (e.g., GPS module, Glonass module, Beidou module, or Galileo module), an NFC module 2280, and a Radio Frequency (RF) module 2290.

The cellular module 2210 may provide, for example, a voice call, a video call, a message service, or an internet service through a communication network. According to one embodiment, the cellular module 2210 may perform discrimination and authentication of the electronic device 2010 within the communication network by using the subscriber identification module (e.g., a SIM card) 2240. According to one embodiment, the cellular module 2210 may perform at least some of the multimedia control functions that may be provided by the processor 2100. According to one embodiment, the cellular module 2210 may include a Communication Processor (CP).

Each of the WiFi module 2230, the Bluetooth module 2250, the GNSS module 2270, and the NFC module 2280 may include, for example, a processor to process data transmitted/received through a corresponding module. According to a certain embodiment, at least some (e.g., two or more) of the cellular module 2210, the WiFi module 2230, the Bluetooth module 2250, the GNSS module 2270, and the NFC module 2280 may be incorporated in a single Integrated Chip (IC) or an IC package.

The RF module 2290 may transmit/receive a communication signal (e.g., an RF signal). The RF module 2290 may include, for example, a transceiver, a Power Amp Module (PAM), a frequency filter, a Low Noise Amplifier (LNA), or an antenna. According to another embodiment, at least one of the cellular module 2210, the WiFi module 2230, the Bluetooth module 2250, the GNSS module 2270, and the NFC module 2280 may transmit/receive an RF signal through one or more separate RF modules.

The subscriber identification module 2240 may include, for example, a card that includes a subscriber identification module and/or an embedded SIM, and may also include intrinsic identification information (e.g., Integrated Circuit Card IDentifier (ICCID)) or subscriber information (e.g., International Mobile Subscriber Identity (IMSI)).

The memory 2300 (e.g., the memory 1300) may include, for example, an internal memory 2320 or an external memory 2340. The internal memory 2320 may include at least one of, for example, a volatile memory (e.g., Dynamic RAM (DRAM), Static RAM (SRAM), or Synchronous DRAM (SDRAM)), a non-volatile memory (e.g., One Time Programmable ROM (OTPROM), Programmable ROM (PROM), Erasable and Programmable ROM (EPROM), Electrically Erasable and Programmable ROM (EEPROM), mask ROM, flash ROM, flash memory (e.g., NAND flash memory, or NOR flash memory), hard drive, or Solid-State Drive (SSD)).

The external memory 2340 may further include a flash drive (e.g., Compact Flash (CF), Secure Digital (SD), Micro Secure Digital (Micro-SD), Mini Secure Digital (Mini-SD), extreme Digital (xD), Multi-Media Card (MMC), or memory stick). The external memory 2340 may be functionally and/or physically connected to the electronic device 2010 through various interfaces.

For example, the sensor module 2400 may measure a physical quantity or may sense an operating status of the electronic device 2010, and may then convert the measured or sensed information into electric signals. The sensor module 2400 may include at least one of, for example, a gesture sensor 2400A, a gyro sensor 2400B, an atmospheric pressure sensor 2400C, a magnetic sensor 2400D, an acceleration sensor 2400E, a grip sensor 2400F, a proximity sensor 2400G, a color sensor 2400H (e.g., RGB (Red, Green, Blue) sensor), a biometric sensor 2400I, a temperature/humidity sensor 2400J, an illuminance sensor 2400K, and an Ultra-Violet (UV) sensor 2400M. Additionally, or alternatively, the sensor module 2400 may include, for example, an E-nose sensor, an ElectroMyoGraphy (EMG) sensor (not illustrated), an ElectroEncephaloGram (EEG) sensor, an ElectroCardioGram (ECG) sensor, an Infra-Red (IR) sensor, an iris sensor, and/or a fingerprint sensor. The sensor module 2400 may further include a control circuit for controlling one or more sensors incorporated therein. In a certain embodiment, the electronic device 2010 may further include a processor configured to control the sensor module 2400 as a part of the processor 2100 or separate from the processor 2100 so as to control the sensor module 2400 while the processor 2100 is in the sleep state.

The input device 2500 may include a touch panel 2520, a (digital) pen sensor 2540, a key 2560, or an ultrasonic input device 2580. As the touch panel 2520, at least one of, for example, a capacitive type touch panel, a resistive type touch panel, an infrared type touch panel, and an ultrasonic type touch panel may be used. Also, the touch panel 2520 may further include a control circuit. The touch panel 2520 may further include a tactile layer so as to provide a tactile reaction to the user.

The (digital) pen sensor 2540 may be, for example, a portion of the touch panel or may include a separate recognition sheet. The key 2560 may include, for example, a physical button, an optical key, or a keypad. The ultrasonic input device 2580 may sense, through a microphone (e.g., a microphone 2880), ultrasonic waves generated by an input tool so as to confirm data corresponding to the sensed ultrasonic waves.

The display 2600 (e.g., the display 1600) may include a panel 2620, a hologram device 2640, or a projector 2660. The panel 2620 may include a configuration that is the same as or similar to that of the display 1600 of FIG. 33. The panel 2620 may be implemented to be, for example, flexible, transparent, or wearable. The panel 2620 may be configured as a single module with the touch panel 2520. The hologram device 2640 may show a stereoscopic image in the air using interference of light. The projector 2660 may project light onto a screen so as to display an image. The screen may be located, for example, inside or outside the electronic device 2010. According to one embodiment, the display 2600 may further include a control circuit to control the panel 2620, the hologram device 2640, or the projector 2660.

The interface 2700 may include, for example, a High-Definition Multimedia Interface (HDMI) 2720, a Universal Serial Bus (USB) 2740, an optical interface 2760, or a D-subminiature (D-sub) 2780. For example, the interface 2700 may be included in the communication interface 1700 illustrated in FIG. 33. Additionally, or alternatively, the interface 2700 may include, for example, a Mobile High-definition Link (MHL) interface, a Secure Digital (SD) card/Multi-Media Card (MMC) interface, or an Infrared Data Association (IrDA) standard interface.

The audio module 2800 may bi-directionally convert, for example, sound and electric signals. At least some of the components of the audio module 2800 may be included in, for example, the input/output interface 1500 illustrated in FIG. 33. The audio module 2800 may process sound information input or output through, for example, a speaker 2820, a receiver 2840, an earphone 2860, or a microphone 2880.

The camera module 2910 is a device that is capable of photographing, for example, a still image and a video image, and according to one embodiment, the camera module 2910 may include at least one image sensor (e.g., a front sensor or a rear sensor), a lens, an Image Signal Processor (ISP), or a flash (e.g., LED or xenon lamp).

The power management module 2950 may manage, for example, the electric power of the electronic device 2010. According to one embodiment, the power management module 2950 may include a Power Management Integrated Circuit (PMIC), a charger Integrated Circuit (IC), or a battery or fuel gauge. The PMIC may be configured as a wired and/or wireless charge type. The wireless charging type may include, for example, a magnetic resonance type, a magnetic induction type, or an electromagnetic wave type, and may further include an additional circuit for wireless charging (e.g., a coil loop, a resonance circuit, or a rectifier). The battery gauge may measure the residual capacity of the battery 2960, and a voltage, a current, or a temperature during the charge. The battery 2960 may include, for example, a rechargeable battery and/or a solar battery.

The indicator 2970 may indicate a specific status (e.g., a booting status, a message status, or a charged status) of the electronic device 2010 or of a part thereof (e.g., AP 2100). The motor 2980 may convert an electric signal into a mechanical vibration, and may generate, for example, a vibration or a haptic effect. Although not illustrated, the electronic device 2010 may include a processor (e.g., a GPU) to support a mobile TV. The processor to support a mobile TV may process media data according to the standards of, for example, Digital Multimedia Broadcasting (DMB), Digital Video Broadcasting (DVB), or MediaFlo™

Each of the above-described component elements of hardware according to the present disclosure may be configured with one or more components, and the names of the corresponding component elements may vary based on the type of electronic device. The electronic device according to various embodiments of the present disclosure may include at least one of the aforementioned elements. Some elements may be omitted or other additional elements may be further included in the electronic device. Also, some of the hardware components according to various embodiments may be combined into one entity, which may perform functions identical to those of the relevant components before the combination.

FIG. 35 is a block diagram illustrating a program module according to various embodiments. According to one embodiment, a program module 3100 (e.g., the program 1400) may include an Operating System (OS) that controls resources associated with an electronic device (e.g., the electronic device 1010) and/or various applications (e.g., the application program 1470) that are driven on the operating system. The operating system may be, for example, Android, iOS, Windows, Symbian, Tizen, or Bada.

The program module 3100 may include a kernel 3200, a middleware 3300, an Application Programming Interface (API) 3600, and/or an application 3700. At least a part of the program module 3100 may be preloaded on the electronic device, or may be downloaded from an external electronic device (e.g., the electronic device 1020 or 1040, or the server 1060).

The kernel 3200 (e.g., the kernel 1410) may include, for example, a system resource manager 3210 and/or a device driver 3230. The system resource manager 3210 may perform, for example, a control, allocation, or recovery of a system resource. According to one embodiment, the system resource manager 3210 may include, for example, a process management unit, a memory management unit, or a file system management unit. The device driver 3230 may include, for example, a display driver, a camera driver, a Bluetooth driver, a common memory driver, a USB driver, a keypad driver, a WiFi driver, an audio driver, or an Inter-Process Communication (IPC) driver.

The middleware 3300 may provide, for example, a function that is commonly required by the applications 3700, or may provide various functions to the applications 3700 through the API 3600 such that the applications 3700 can efficiently use the limited system resources within the electronic device. According to one embodiment, the middleware 3300 (e.g., the middleware 1430) may include at least one of a runtime library 3350, an application manager 3410, a window manager 3420, a multimedia manager 3430, a resource manager 3440, a power manager 3450, a database manager 3460, a package manager 3470, a connectivity manager 3480, a notification manager 3490, a location manager 3500, a graphic manager 3510, and a security manager 3520.

The runtime library 3350 may include, for example, a library module that is used by a compiler in order to add a new function through a program language while the applications 3700 are executed. The runtime library 3350 may perform, for example, input/output management, memory management, or a function for an arithmetic function.

The application manager 3410 may manage, for example, a life cycle of at least one application among the applications 3700. The window manager 3420 may manage a GUI resource that is used in a screen. The multimedia manager 3430 may grasp a format required for reproducing various media files, and may perform encoding or decoding of the media files by using a codec that is suitable for the corresponding format. The resource manager 3440 may manage a resource, such as a source code, a memory, or a storage space, of at least one application among the applications 3700.

The power manager 3450 is operated together with, for example, a Basic Input/Output System (BIOS) so as to manage a battery or a power source, and may provide, for example, power information that is required for operating the electronic device. The database manager 3460 may generate, retrieve, or change a database to be used by at least one application among the applications 3700. The package manager 3470 may manage the installation or update of an application that is distributed in the form of a package file.

The connectivity manager 3480 may manage, for example, a wireless connection of WiFi, Bluetooth, or the like. The notification manager 3490 may display or notify events, such as an arrival message, appointment, and proximity notification in a manner that does not disturb the user. The location manager 3500 may manage position information of the electronic device. The graphic manager 3510 may manage a graphic effect to be provided to the user or a user interface associated therewith. The security manager 3520 may provide all security functions required for, for example, system security, or user authentication. According to one embodiment, in the case where the electronic device (e.g., the electronic device 1010) includes a phone function, the middleware 3300 may include a telephony manager to manage a voice or video call function of the electronic device.

The middleware 3300 may include a middleware module that forms a combination of various functions of the above-described components. The middleware 3300 may provide a module that is specialized for each kind of operation system in order to provide differentiated functions. In addition, the middleware 3300 may dynamically delete some of the existing components or add new components.

The API 3600 (e.g., the API 1450) is, for example, a collection of API programming functions, and may be provided in different configurations according to operation systems. For example, Android or iOS may provide one API set for each platform and Tizen may provide two or more API sets for each platform.

The applications 3700 (e.g., the application program 1470) may include, for example, one or more applications that can execute, for example, the functions of home 3710, dialer 3720, SMS/MMS 3730, Instant Message (IM) 3740, browser 3750, camera 3760, alarm 3770, contact 3780, voice dial 3790, e-mail 3800, calendar 3810, media player 3820, album 3830, and watch 3840, health care (e.g., measurement of a quantity of motion, or blood sugar), or provision of environmental information (e.g., provision of atmospheric pressure, humidity, or temperature information).

According to one embodiment, the applications 3700 may include an application that supports information exchange between the electronic device (e.g., the electronic device 1010) and the external electronic devices (e.g., the electronic devices 1020 and 1040) (hereinafter, the application will be referred to as an "information exchange application" for the convenience of description). The information exchange application may include, for example, a notification relay application to transmit specific information to the external electronic devices, or a device management application to manage the external electronic devices.

For example, the notification relay application may include a function of relaying notification information generated from any other application of the electronic device (e.g., an SMS/MMS application, an e-mail application, a healthcare application, or an environment information application) to the external electronic devices (e.g., the electronic devices 102 and 104). In addition, the notification relay application may receive notification information from, for example, an external electronic device, and may provide the notification information to the user.

The device management application may manage (e.g., install, delete, or update) at least one function of an external electronic device (e.g., the electronic device 1020 or 1040) that communicates with the electronic device (e.g., turn-on/turn-off of the external electronic device itself (or some components thereof) or adjustment of brightness (or resolution) of a display), an application operated in the external electronic device, or a service provided by the external electronic device (e.g., a telephony service or a message service).

According to one embodiment, the applications 3700 may include an application designated according to an attribute of an external electronic device (e.g., the electronic device 1020 or 1040) (e.g., a healthcare application of a mobile medical device). According to one embodiment, the applications 3700 may include an application received from an external electronic device (e.g., the server 1060 or the electronic device 1020 or 1040). According to one embodiment, the applications 3700 may include a preloaded application or a third-party application that is capable of being downloaded from the server. The names of the components of the program module 3100 according to the illustrated embodiment may vary depending on the kind of operation system.

According to various embodiments, at least a portion of the program module 3100 may be implemented by software, firmware, hardware, or a combination of two or more thereof. At least a portion of the program module 3100 may be implemented (e.g., executed) by, for example, a processor (e.g., the processor 2100). At least a portion of the program module 3100 may include, for example, a module, a program, a routine, a set of instructions, or a process for performing one or more functions.

The term "module" as used herein may, for example, mean a unit including one of hardware, software, and firmware or a combination of two or more of them. The "module" may be interchangeably used with, for example, the term "unit", "logic", "logical block", "component", or "circuit". The "module" may be a minimum unit of an integrated component element or a part thereof. The "module" may be a minimum unit for performing one or more functions or a part thereof. The "module" may be mechanically or electronically implemented. For example, the "module" according to the present disclosure may include at least one of an Application-Specific Integrated Circuit (ASIC) chip, a Field-Programmable Gate Arrays (FPGA), and a programmable-logic device for performing operations which has been known or are to be developed hereinafter.

According to various embodiments, at least some of the devices (for example, modules or functions thereof) or the method (for example, operations) according to the present disclosure may be implemented by a command stored in a computer-readable storage medium in a programming module form. The instruction, when executed by a processor (e.g., the processor 1200), may cause the one or more processors to execute the function corresponding to the instruction. The computer-readable storage medium may be, for example, the memory 1300.

The computer readable recoding medium may include a hard disk, a floppy disk, magnetic media (e.g., a magnetic tape), optical media (e.g., a Compact Disc Read Only Memory (CD-ROM) and a Digital Versatile Disc (DVD)), magneto-optical media (e.g., a floptical disk), a hardware device (e.g., a Read Only Memory (ROM), a Random Access Memory (RAM), a flash memory), and the like. In addition, the program instructions may include high class language codes, which can be executed in a computer by using an interpreter, as well as machine codes made by a compiler. The aforementioned hardware device may be configured to operate as one or more software modules in order to perform the operation of the present disclosure, and vice versa.

The programming module according to the present disclosure may include one or more of the aforementioned components or may further include other additional components, or some of the aforementioned components may be omitted. Operations executed by a module, a programming module, or other component elements according to various embodiments of the present disclosure may be executed sequentially, in parallel, repeatedly, or in a heuristic manner. Furthermore, some operations may be executed in a different order or may be omitted, or other operations may be added. Various embodiments disclosed herein are provided merely to easily describe technical details of the present disclosure and to help the understanding of the present disclosure, and are not intended to limit the scope of the present disclosure. Accordingly, the scope of the present disclosure should be construed as including all modifications or various other embodiments based on the technical idea of the present disclosure.

While the present disclosure has been shown and described with reference to certain embodiments thereof, it will be understood by those skilled in the art that various changes in form and details may be made therein without departing from the spirit and scope of the present disclosure as defined by the appended claims.

## Claims

1. An electronic device with a pressure-sensitive input device, the electronic device comprising:
a cover having a touch panel and a display panel stacked on one face of the touch panel so as to display a screen; and
a pressure-sensitive input device including at least one pressing sensor unit that is disposed on a rear face of the cover so as to sense pressing performed on the cover and to implement an input according to the pressing.

2. The electronic device of claim 1, wherein the cover is provided as a display panel,
the display panel includes a screen display unit including a first screen region and a second screen region, at least a portion of which is bent from the first screen region, and an opaque layer positioned around the screen display unit, and
the pressing sensor unit is disposed on at least one of a rear face of the second screen region and a rear face of the opaque layer.

3. The electronic device of claim 2, wherein the pressing sensor unit includes:
a capacitance-sensing unit formed adjacent to one face of the cover; and
a pressure-sensing unit formed adjacent to one face of the capacitance-sensing unit.

4. The electronic device of claim 2, wherein the pressing sensor unit includes:
first and second conductive members;
a pressure-sensitive layer that is disposed between the first conductive member and the second conductive member and has a resistance which is variable according to a pressure according to a touch of an object; and
a spacer layer that fixedly spaces the pressure-sensitive layer apart from at least one of the first and second conductive members.

5. The electronic device of claim 4, wherein each of opposite side faces of the pressing sensor unit includes an elastic support that provides elasticity according to pressing of the pressing sensor unit, and
the elastic support supports the pressing sensor unit between the display panel and a display bracket disposed below the display panel.

6. The electronic device of claim 5, wherein the elastic support is formed of an elastic double-sided tape.

7. The electronic device of claim 5, wherein the pressing sensor unit includes:
a first sensing sensor and a second sensing sensor disposed adjacent to the first sensing sensor; and
an elastic support member is included between the first sensing sensor and the second sensing sensor so as to suppress the first sensing sensor and the second sensing sensor from interfering with each other when the first sensing sensor and the sensing sensor are pressed.

8. The electronic device of claim 7, wherein the elastic support member is formed of an elastic double-sided tape.

9. The electronic device of claim 4, wherein the spacer layer includes a silicon material.

10. The electronic device of claim 2, wherein the pressing sensor unit is provided on a rear face of the second screen region, and
through the second screen region, at least one of a first user input through a touch of the second screen region, a second user input according to pressing of the pressing sensor unit, and a third user input through a touch of the second screen region and pressing of the pressing sensor unit is implemented.

11. The electronic device of claim 2, wherein the pressing sensor unit is provided on the rear face of the opaque layer, and
through the opaque layer, at least one of a first user input through a touch of the second screen region, a second user input according to pressing of the pressing sensor unit, and a third user input through a touch of the second screen region and pressing of the pressing sensor unit is implemented.

12. An electronic device comprising:
a cover that forms at least a portion of an outer surface of the electronic device;
a capacitance-sensing unit formed adjacent to one face of the cover; and
a pressure-sensing unit formed adjacent to one face of the capacitance-sensing unit; and
a processor,
wherein the processor is set to confirm a position corresponding to a user input adjacent to the cover using the capacitance-sensing unit and to perform the first designated function based at least on the position when situation information related to the electronic device satisfies a first designated condition, and
the processor is set to confirm a pressure corresponding to the user input using the capacitance-sensing unit and the pressure-sensing unit and perform the second designated function based at least on the pressure when the situation information satisfies a second designated condition.

13. The electronic device of claim 12, wherein the first designated condition is set so as to perform a third designated function simultaneously using the capacitance-sensing unit and the pressure-sensing unit in at least a part of a predetermined time period.

14. The electronic device of claim 13, wherein the third designated function is set to perform a user experience control (UX control) based on the pressure.

15. The electronic device of claim 14, wherein the UX control includes at least one of a menu control, a volume control, and an application control.

16. The electronic device of claim 13, further including a spacer unit included between the capacitance-sensing unit and the pressure-sensing unit so as to fixedly space the capacitance-sensing unit and the pressure-sensing unit apart from each other.

17. The electronic device of claim 13, further including an input unit that is provided on a face of the capacitance-sensing unit and a face of the pressure-sensing unit in order to implement an input by sensing a separate touch or pressing.

18. The electronic device of claim 17, wherein at least one of a first user input through an input value detected according to driving of the input unit, a second user input through a sensing value detected by the capacitance-sensing unit and the pressure-sensing unit, and a third user input according to a combination of an input value of the input unit and sensing values detected by capacitance-sensing unit and the pressure-sensing unit is implemented.

19. An electronic device comprising:
a cover that forms at least a portion of an outer surface of the electronic device;
a capacitance-sensing unit that is formed adjacent to one face of the cover and reacts to a user input acquired through the cover so as to sense a variation in capacitance corresponding to the user input; and
a pressure-sensing unit that is formed adjacent to one face of the capacitance-sensing unit and is selectively activated based on the user input or the situation information for the electronic device so as to sense a variation in pressure corresponding to the user input.

20. The electronic device of claim 19, wherein, when the situation information related to the electronic device satisfies a first designated condition, the capacitance-sensing unit is set to be activated so as to be used to confirm a position corresponding to a user input adjacent to the cover, and
when the situation information satisfies a second designated condition, the capacitance-sensing unit and the pressure-sensing unit is set so as to be activated to be used to confirm a pressure corresponding to the user input.

21. The electronic device of claim 20, wherein the first designated condition is further set so as to perform a third designated function simultaneously using the capacitance-sensing unit and the pressure-sensing unit in at least a part of a predetermined time period.

22. The electronic device of claim 21, wherein the third designated function is set to perform a user experience control (UX control) based on the pressure.

23. The electronic device of claim 22, wherein the UX control includes at least one of a menu control, a volume control, and an application control.

24. The electronic device of claim 19, further comprising an input unit that implements an input by sensing a touch or pressing according to the user input,
wherein the capacitance-sensing unit and the pressure-sensing unit are mounted at a position corresponding to the input unit.

25. The electronic device of claim 24, wherein the electronic device implements a first user input through an input value detected according to driving of the input unit, a second user input through a sensing value detected by the capacitance-sensing unit and the pressure-sensing unit, and/or a third user input according to a combination of an input value of the input unit and sensing values detected by capacitance-sensing unit and the pressure-sensing unit.

26. An input device comprising:
a first input unit that implements an input in response to a user input according to at least one of pressing and a touch; and
a second input unit that is disposed above a position of the first input unit,
wherein the second input unit includes:
a first sensing unit that reacts to a user input so as to sense a variation in capacitance corresponding to the user input; and
a second sensing unit that is formed adjacent to one face of the first sensing unit so as to senses a variation in pressure corresponding to the user input, and
when situation information, which satisfies a designated condition, is input to the input device, at least one of the first sensing unit and the second sensing unit is activated so as to perform the designated function.

27. The electronic device of claim 26, wherein when situation information, which satisfies a pre-set first designated condition among the designated conditions, is input to the input device, the first sensing unit is activated, and the pre-set first designated function among the designated functions is performed based on the activation of the first sensing unit.

28. The electronic device of claim 27, wherein when situation information, which satisfies a condition based on a time period pre-set in addition to the first designated condition, is input, the first sensing unit and the second sensing unit are at least partially used so as to perform a third designated function.

29. The electronic device of claim 27, wherein, when situation information, which satisfies a second designated condition pre-set unlike the first designated condition among the designated conditions, is input to the input device, the first sensing unit and the second sensing unit are activated, and among the designated functions, the second designated function pre-set unlike the second designated function is performed based on activation of the first sensing unit and the second sensing unit.

30. The electronic device of claim 27, wherein the input device includes a processor that performs control such that the designated functions are performed according to the activation of at least one of the first sensing unit and the second sensing unit.

31. The electronic device of claim 26, wherein the input unit is provided as one of a pressing sensing unit that senses a physical variation according to pressing and a touch panel unit that senses a variation in capacitance according to a touch,
the first sensing unit is configured as a capacitance-sensing unit that senses the variation of capacitance, and
the second sensing unit is configured as a pressure-sensing unit that senses the variation of pressure.

32. The electronic device of claim 26, wherein, with respect to an input unit, the electronic device implements a first user input through an input value detected according to the user input, a second user input through a sensing value detected by the first sensing unit and the second sensing unit according to the user input, and/or a third user input according to a combination of an input value of the input unit and sensing values detected by the first sensing unit and the second sensing unit.
